# EUROPÄISCHE PATENTANMELDUNG

(11) **EP 2 626 864 A1**
(43) Veröffentlichungstag der Anmeldung: **14.08.2013**
(21) Anmeldenummer: 12154563.6
(22) Anmeldetag: 08.02.2012
(51) Int. Cl.: G11C 27/02, H03K 17/74, G01R 19/25

(54) **Vorrichtung und Verfahren zum Abtasten eines Signals**

(71) Anmelder: VEGA Grieshaber KG, 77709 Wolfach (DE)
(72) Erfinder: Fischer, Michael, 72275 Alpirsbach (DE); Corbe, Bernhard, 77746 Schutterwald (DE)
(74) Vertreter: Kopf, Korbinian Paul

(57) **Zusammenfassung**

Es wird das Abtasten eines Signals mit einer Abtastvorrichtung (200,200''',300) beschrieben. Die Abtastvorrichtung enthält eine Abtastbrücke (27,27''',28), ein erstes passives Bauelement (21), ein zweites passives Bauelement (20), wobei die Abtastbrücke (27,27''',28) zumindenst zwei Dioden (22,23) aufweist und wobei die zwei passiven Bauelemente durch je einen Anschluss direkt miteinander verbunden sind, so dass die beiden Anschlüsse (201,202) auf einem gemeinsamen Potenzial liegen.

## Beschreibung

### Technisches Gebiet

Die vorliegende Erfindung betrifft das Gebiet der Signalverarbeitung für die Messtechnik. Insbesondere betrifft die Erfindung das Messen nach dem Prinzip der Laufzeitmessung, beispielsweise in einem Füllstandmessgerät, einem Grenzstandmessgerät oder in einem Messgerät, das das Prinzip der geführten Mikrowelle ausnutzt. Die vorliegende Erfindung mag eine Abtastvorrichtung, ein Messgerät mit einer Abtastvorrichtung, ein Verfahren zum Abtasten eines Signals, ein computerlesbares Speichermedium mit einem Programm zum Ausführen des Verfahrens zum Abtasten eines Signals und ein Programmprodukt zum Ausführen des Verfahrens zum Abtasten eines Signals betreffen.

Der Vortrag "Low-Cost Sampling Down Converter für UWB-Sensor Anwendungen" von Alexander Reisenzahn et al., Johannes Kepler Universität Linz, Institut für Mikroelektronik, geht auf die sequenzielle Abtastung und die Abtastpulsgenerierung ein.

Das Verfahren der sequenziellen Abtastung wird in der Elektrotechnik in verschiedenen Anwendungsfällen genutzt. Es ist jedoch auf periodisch wiederkehrende Signale beschränkt. Die sequenzielle Abtastung kommt u. a. in Sampling Oszilloskopen zum Einsatz und wird in der Füllstandmesstechnik angewendet. Im Gegensatz zur Abtastung in Echtzeit (Real Time Sampling) kommt die sequenzielle Abtastung mit einer geringere Abtastfrequenz aus und setzt bei der Abtastung das ursprüngliche Signal auf eine niedrigere Frequenz um. Zu diesem Zweck existiert eine Vielzahl von Abtastschaltungen oder Sampling Schaltungen.

Die Druckschrift DIE 10 2005 024 643 A1 betrifft eine Abtastschaltung zur sequenziellen Abtastung eines breitbandigen periodischen Eingangssignals, wobei ein nicht lineares Bauelement vorgesehen ist, dem ein impulsförmiges Abtastsignal zugeführt wird. Als nicht lineares Bauelement ist ein Feldeffekttransistor vorgesehen.

Die Druckschrift Sampling Notes von Tektronix Inc., S. W. Millikan Way, P. O. Box 500 0 Beaverton, Oregon, Revision 1.0, 13. Januar 2009, beschreibt Konzepts und Systeme für Sampling Oszilloskope und insbesondere die sequentielle Abtastung.

Die Druckschrift "Sampling Oscilloscope Techniques", Tektronix, Technique Primer 47W-7209, 1989, beschreibt unterschiedliche Abtastkonzepte.

Die Druckschrift "Schottky Diodes for High Volume, Low Cost Applications", Application Note 942, Hewlett Packard, Mai 1973, beschreibt ein Sampling Gate mit vier Dioden.

Es mag ein Bedürfnis sein, ein effizientes Abtasten eines Signals zu ermöglichen.

### Zusammenfassung der Erfindung

Es mag eine Abtastvorrichtung, ein Messgerät mit einer Abtastvorrichtung, ein Verfahren zum Abtasten eines Signals, ein computerlesbares Speichermedium mit einem Programm zum Ausführen des Verfahrens zum Abtasten eines Signals und ein Programmprodukt zum Ausführen des Verfahrens zum Abtasten eines Signals beschrieben werden.

Aspekte der Erfindung mögen sich aus den Gegenständen der unabhängigen Patentansprtiche ergeben. Weitere Ausführungsbeispiele mögen in den abhängigen Ansprüchen und der folgenden Beschreibung angegeben sein.

Gemäß einem Aspekt der vorliegenden Erfindung wird eine Abtastvorrichtung beschrieben, welche eine Abtastbrücke, ein erstes passives Bauelement und ein zweites passives Bauelement aufweist. Die Abtastbrücke weist zumindest zwei Dioden auf, wobei jede der Dioden eine Anode und eine Kathode aufweist. Die zumindest zwei Dioden sind in Reihe geschaltet und bilden einen ersten Brückenzweig. Der erste Brückenzweig wird gebildet, indem die Anode der einen Diode mit der Kathode der anderen Diode an einem Eingangsanschluss verbunden ist. Ein zweiter Brückenzweig der Abtastbücke wird gebildet, indem zumindest zwei passive Brückenbauelemente in Reihe geschaltet werden, wobei als Folge einer Koppelverbindung bei der Reihenschaltung der zumindest zwei passiven Brückenbauelemente ein Ausgangsanschluss gebildet werden mag. Die Verbindungsstelle oder die Koppelverbindung der zumindest zwei Dioden des ersten Brückenzweigs mag einen Eingangsanschluss ausbilden. Entsprechend mag der erste Brückenzweig auch Eingangszweig und der zweite Brückenzweig Ausgangszweig genannt werden.

Die im Wesentlichen symmetrisch aufgebauten Brückenzweige sind zum Bilden der Abtastbrücke parallel geschaltet, so dass eine Anode einer Diode des ersten Brückenzweiges mit einem freien Ende eines passiven Bmckenbauelements des zweiten Brückenzweigs an einem positiven Abtastanschluss verbunden sein mag. Eine freie Kathode einer Diode des ersten Brückenzweigs mag mit einem freien Ende eines anderen passiven Brückenbauelements des zweiten Bmckenzweigs an einem negativen Abtastanschluss verbunden sein.

Der Ausgangsanschluss, der Eingangsanschluss, der positive Abtastanschluss und der negative Abtastanschluss mag sich durch den Aufbau der Abtastbrücke zwischen den beschriebenen Bauelementen an den jeweiligen Verbindungsstellen ausbilden, beispielsweise zwischen den Dioden oder zwischen den passiven Brückenbauelementen. Eine Diode kann ein Ausführungsbeispiel eines passiven Brückenbauelements sein. Ein Anschluss (Terminal), der sich zwischen den Bauelementen ausbildet kann eine Kontaktfläche aufweisen.

Ein passives Bauelement, welches zum Bilden der Abtastbrücke genutzt wird, mag als passives Brückenbauelement bezeichnet werden, um auszudrücken, dass es der Abtastbrücke zuzuordnen ist.

Als freies Ende eines Bauelements mag ein Anschluss (Link) des Bauelements bezeichnet werden, welcher nicht für die Realisierung eines Brückenzweigs durch eine Reihenschaltung von Bauelementen genutzt wird. Ein Anschluss (Link) mag in einem Beispiel ein Verbindungsdraht, ein Bondingdraht oder ein "Beinchen" eines Bauelements sein.

Mit dem positiven Abtastanschluss der Abtastbrücke ist ein erster Anschluss des ersten passiven Bauelements verbunden und ein erster schluss des zweiten passiven Bauelements ist mit dem negativen Abtastanschluss der Abtastbrücke verbunden.

Ein zweiter Anschluss des ersten passiven Bauelements ist mit einem zweiten schluss des zweiten passiven Bauelements verbunden, so dass die beiden zweiten Anschlüsse auf einem gemeinsamen Potenzial oder auf gleichem Potenzial liegen.

Bei den passiven Bauelementen oder bei passiven Brückenbauelementen mag es sich in unterschiedlichen Ausführungsbeispielen um einen Widerstand, eine Spule, eine Diode und/oder eine Filterstruktur handeln.

Das erste passive Bauelement und/oder das zweite passive Bauelement mag angepasst sein, eine galvanische Verbindung mit dem Masseanschluss, dem gemeinsamen Bezugspotenzial oder der Schaltungsmasse herzustellen. Daher kann als erstes passives Bauelement und/oder als zweites passives Bauelement beispielsweise ein Widerstand oder eine Spule eingesetzt werden, jedoch im Wesentlichen kein Kondensator.

Eine Abtastbrücke oder eine Sampling Bridge kann alternativ auch als Sampling Gate bezeichnet werden.

Wegen des symmetrischen Aufbaus der Abtastbrücke aus parallel gekoppelten Zweigen, die mit seriell geschalteten Bauelementen des gleichen Typs aufgebaut sein mögen, kann diese Abtastbrücke als symmetrische Abtastbrücke oder als symmetrisch aufgebaute Abtastbrücke bezeichnet werden.

Gemäß einem anderen Aspekt der vorliegenden Erfindung mag eine weitere Abtastvorrichtung, die das technische Konzept der Erfindung realisiert, einen einzigen Abtastbrückenzweig mit zumindest einem passiven Brückenbauelement und mit zumindest einer Diode aufweisen.

Bei solch einem Aufbau mag ein freies Ende des passiven Brückenbauelements einen Eingangsanschluss aufweisen und ein anderes Ende des passiven Brückenbauelements mit einer Anode der zumindest einen Diode verbunden sein. Bei diesem Aufbau der Abtastbrücke mag eine Kathode der zumindest einen Diode einen Ausgangsanschluss aufweisen.

Der Ausgangsanschluss mag mit einem negativen Abtastanschluss, einem ersten Anschluss eines Kondensators und einem ersten Anschluss eines passiven Bauelements verbunden sein. Ein zweiter Anschluss des Kondensators und ein zweiter Anschluss des passiven Bauelements mag so verbunden sein, dass die beiden Anschlüsse auf einem gemeinsamen Potenzial liegen, beispielsweise einem Massepotenzial der Abtastvorrichtung.

Wegen des Aufbaus der Abtastbrücke der weiteren Abtastvorrichtung mit einer reduzierten Anzahl an Bauelementen mit einem passiven Brückenbauelement und einer Diode mag sich ein unsymmetrische Aufbau der Abtastbrücke oder eine unsymmetrische Abtastbrücke ergeben. Weitere Ausgestaltungen dieser Abtastvorrichtung mit einer unsymmetrischen Abtastbrücke mögen entsprechend den Ausgestaltungen der Abtastvorrichtung mit symmetrischer Abtastbrücke ausgeführt sein.

Gemäß einem anderen Aspekt der vorliegenden Erfindung wird ein Verfahren zum Abtasten eines Signals mittels der erfindungsgemäßen Abtastvorrichtung beschrieben. Das Verfahren sieht vor, dass das abzutastende Signal an den Eingangsanschluss einer Abtastbrücke einer bereitgestellten Abtastvorrichtung angelegt wird. Ferner sieht das Verfahren das Bereitstellen eines ersten Abtastsignals an einem positiven Abtastanschluss der Abtastvorrichtung vor und im Wesentlichen gleichzeitig das Bereitstellen eines zweiten Abtastsignals an den negativen Abtastanschluss der Abtastvorrichtung. Zum Bereitstellen eines Signals an einem Anschluss mag der entsprechende Anschluss mit einem entsprechenden Signal versorgt werden.

Das Verfahren sieht weiter das Bereitstellen eines Ausgangssignals an einem Ausgangsanschluss der Abtastvorrichtung vor. Schließlich erfolgt ein Entladen des positiven Abtastanschlusses über das erste passive Bauelement der Abtastvorrichtung und das Entladen des negativen Abtastanschlusses über das zweite passive Bauelement zu einem gemeinsamen Potenzial des ersten passiven Bauelements und des zweiten passiven Bauelements.

In einem anderen Ausführungsbeispiel mag ein Verfahren zum Abtasten eines Signals mittels der unsymmetrischen Abtastbrücke angegeben sein. Das Verfahrens mag vorsehen, dass an dem Eingangsanschluss der reduzierten Abtastbrücke das abzutastende Signal angelegt wird. Zu dem Zeitpunkt, zu dem dieses abzutastende Signal abgetastet werden soll, mag ein Abtastsignal an dem negativen Abtastanschluss bereitgestellt werden, beispielsweise auch über einen Kondensator zur Gleichstromunterdrückung. Durch das negative Abtastsignal, mag die Diode für die Zeitdauer des Anliegens des negativen Abtastsignals leiten und das abzutastende Signal mag als abgetastetes Ausgangssignal an dem Ausgangsanschluss oder an dem negativen Abtastanschluss bereitgestellt werden. Der am Ausgangsanschluss vorhandene Kondensator mag das Ausgangssignal, insbesondere eine dem Ausgangssignal entsprechende Ladung, speichern und das passive Bauelement mag nach dem Wegfallen des negativen Abtastsignals für einen Ladungsausgleich einer auf dem Kondensator zur Gleichstromunterdrückung gespeicherten Ladung sorgen. Das abgetastete Signal kann als Ausgangssignal an dem Ausgangsanschluss der reduzierten Brückenschaltung bereitgestellt werden.

Gemäß noch einem anderen Aspekt der vorliegenden Erfindung wird ein Messgerät beschrieben, welches eine Sende-/Empfangseinrichtung, eine erfindungsgemäße Abtastvorrichtung und eine Signalverarbeitungseinrichtung zum Bestimmen eines Messwerts aufweist.

Gemäß noch einem anderen Aspekt der vorliegenden Erfindung wird ein computerlesbares Speichermedium beschrieben, auf dem ein Programmcode gespeichert ist, der, wenn er von einem Prozessor ausgeführt wird, zumindest eines der erfindungsgemäßen Verfahren zum Abtasten eines Signals mit einer Abtastvorrichtung ausführt.

Gemäß einem anderen Aspekt der vorliegenden Erfindung wird ein Computer-Programmprodukt beschrieben, welches, wenn es von einem Prozessor ausgeführt wird, zumindest eines der Verfahren zum Abtasten eines Signals mit einer Abtastvorrichtung ausführt.

In anderen Worten mögen das Programm, das auf dem computerlesbaren Speichermedium gespeichert ist oder das Programmprodukt die Abtastvorrichtung derart ansteuern, dass das entsprechende Verfahren zum Abtasten eines Signals ausgeführt wird. Insbesondere mag durch das Programm oder das Programmprodukt die Abtastvorrichtung gesteuert werden.

Es mag eine Idee der Erfindung sein, durch das kurzzeitige Anlegen eines einzigen Abtastsignals oder dem im Wesentlichen gleichzeitigen Anlegen eines positiven Abtastsignals und eines negativen Abtastsignals von der gleichen Größe an eine Abtastbrücke, die Abtastbrücke kurzfristig in einen leitfähigen Zustand zu versetzen und so das momentan anliegende abzutastende Signal am Eingang der Abtastbrücke auf einen Ausgang der Abtastbrücke zu kopieren oder spiegeln und dort zu speichern, um es in ausreichend langer Zeit weiterzuverarbeiten. Während des Auswertens des gespeicherten Signals mag die Abtastbrücke im Wesentlichen derart gesperrt werden, dass ein Ladungsausgleich der von dem Abtastsignal verursachten Ladung zu einem Masseanschluß oder zu einem gemeinsamen Bezugspotenzial möglich ist. Eine Verbindung zwischen Ausgang und Eingang der Abtastbrücke mag jedoch während des Auswertens verhindert werden. Ein Abfließen der Ladung des gespeicherten Signals mag im Wesentlichen verhindert werden.

Die im Wesentlichen parallel angeordneten Brückenzweig der symmetrischen Abtastbrücke mögen im Wesentlichen symmetrisch aufgebaut sein. Der symmetrische Aufbau mag bedeuten, dass dieselbe Anzahl an Dioden und/oder passiven B auelementen in jedem der Brückenzweige verwendet wird. Bei diesem Aufbau mag auch die gleiche Anzahl an Dioden und passiven Bauelementen in den parallelen Brückenzweiges als symmetrisch bezeichnet werden. Insbesondere mögen die Dioden parallel in der im Wesentlichen gleichen Richtung oder Orientierung ausgerichtet sein, insbesondere bezogen auf deren Durchlassrichtung. Das Verbinden der zweiten Anschlüsse der passiven Bauelemente direkt miteinander, ohne im Wesentlichen anderer Bauelemente oder Spannungsquellen dazwischen, mag dazu fuhren, dass diese Anschlüsse auf einem gemeinsamen oder gleichen elektrischen Potenzial liegen. Die verbundenen Anschlüsse, insbesondere die Oberflächen der verbundenen Anschlüsse, mögen folglich eine Äquipotcnzialfläche bilden. Für den Fall, dass dieses gemeinsame Potenzial ein Massepotential ist, mögen die beiden Anschlüsse auf Massepotenzial oder Erdpotenzial liegen. Durch das Verbinden der Anschlüsse der passiven Bauelemente werden die Dioden der Abtastbrücke im Wesentlichen ohne Vorspannung betrieben. Das Vermeiden der Vorspannung mag die Erzeugung, Aufbereitung und Überwachung einer entsprechenden Vorspannung überflüssig machen. Insbesondere mag beispielsweise eine positive oder negative Vorspannung wegfallen. Die passiven Bauelemente, beispielsweise ein Widerstand, eine Induktivität oder eine Filterstruktur, können Ladungen, welche auf dem negativen Abtastanschluss und/oder auf dem positiven Abtastanschluss vorhanden sind, zu dem gemeinsame Bezugspotenzial abführen. Durch eine Erhöhung der Anzahl der Dioden in den jeweiligen Brückenzweigen kann die Schwellenspannung innerhalb eines Abschnittes eines Brückenzweiges erhöht werden, um große Eingangssignale abzutasten, mit denen der Eingangsanschluss versorgt werden mag.

An dem Ausgangsanschluss der Abtastbrücke mag ein sehr empfindlicher Punkt entstehen. In anderen Worten mag dies bedeuten, dass eine Störung, welche auf diesen empfindlichen Punkt oder auf diese Stelle der Abtastvorrichtung wirken mag, das Ausgangssignal sehr stark verfälschen kann. Durch das Vorsehen eines Verstärkers an dem Ausgangsanschluss mag ein solcher Eingriff auf den empfindlichen Punkt vermeidbar sein, wenn ein Eingriff auf die Schaltung erst hinter dem Verstärker erfolgt.

Die Verstärkung des Signals am Ausgangsanschluss der Abtastbrücke durch den Verstärker mag das abgetastete Signal für die weitere Signalverarbeitung in geeigneter Weise aufbereiten, Insbesondere mag die Verstärkung für einen ausreichend hohen Signalpegel sorgen.

Der Ausgangsanschluss der Abtastbrücke mag einen empfindlichen Punkt der Schaltung bezeichnen, da an dem Ausgangsanschluss Signale mit einer sehr kleinen Amplitude auftreten können. Die schwachen Signale können entstehen, da die von der Füllgutoberfläche empfangenen Echos und damit die abzutastenden Signale oft sehr stark abgeschwächt sind. Eine Verstärkung dieser schwachen Signale ist für die weitere Signalverarbeitung nützlich.

Ein Eingriff an der empfindlichen Stelle könnte also die schwachen Signale durch Einbringen einer Störung stark verfälschen. Diese Störung würde dann durch den nachfolgenden Verstärker in gleichem Maß verstärkt werden wie das Nutzsignal. Deshalb mag ein Eingriff erst in Signalrichtung nach dem ersten Verstärker sinnvoll sein, da hier das Echosignal bereits verstärkt vorliegt und die gleiche Störung das Signal nicht mehr so stark verfälschen kann. Entsprechend mag es auch sinnvoll sein, die Entstehung von Störungen an dem empfindlichen Punkt gering zu halten, da die Störungen im gleichen Maß verstärkt würden.

Gemäß einem weiteren Aspekt der vorliegenden Erfindung sind die zumindest zwei passiven Brückenbauelenienie als zumindest zwei Dioden realisiert.

Durch den Einsatz der Dioden als passive Brückenbauelemente mag eine Abtastvorrichtung beschrieben werden, welche eine Abtastbrücke, ein erstes passives Baueleund ein zweites passives Bauelement aufweist. Die Abtastbrücke weist zumindest vier Dioden auf, wobei jede der Dioden eine Anode und eine Kathode aufweist. Zumindest zwei der Dioden sind in Reihe geschaltet und bilden einen ersten Brückenzweig. Der erste Brückenzweig wird gebildet, indem die Anode der einen Diode mit der Kathode der anderen Diode an einem Eingangsanschluss verbunden ist. Ein zweiter Brückenzweig wird entsprechend gebildet, indem zumindest zwei weitere Dioden in Reihe geschaltet sind, wobei bei der Reihenschaltung die Anode der einen weiteren Diode des zweiten Brückenzweiges mit der Kathode der anderen weiteren Diode des zweiten Brückenzweiges an einem Ausgangsanschluss verbunden ist. Die Verbindungsstelle der Dioden des ersten Brückenzweigs mag somit den Eingangsanschluss ausbilden und die Verbindungsstelle der weiteren Dioden des zweiten Brückenzweiges mag den Ausgangsanscliluss ausbilden. Entsprechend mag der erste Brückenzweig auch Eingangszweig und der zweite Brückenzweig Ausgangszweig genannt werden.

Die im Wesentlichen symmetrisch aufgebauten Brückenzweige sind zum Bilden der Abtastbrücke parallel geschaltet, so dass eine Anode einer Diode des ersten Brückenzweigs mit einer Anode einer Diode des zweiten Brückenzweiges an einem positiven Abtastanschluss verbunden ist. Eine Kathode einer Diode des ersten Brückenzweigs ist mit einer Kathode einer Diode des zweiten Brückenzweiges an einem negativen Abtastanschluss verbunden.

Mit dem positiven Abtastanschluss ist ein erster Anschluss eines ersten passiven Bauelements verbunden und ein erster Anschluss des zweiten passiven Bauelements ist mit dem negativen Abtastanschluss verbunden.

Ein zweiter Anschluss des ersten passiven Bauelements ist mit einem zweiten Anschluss des zweiten passiven Bauelements verbunden, so dass die beiden zweiten Anschlüsse auf einem gemeinsamen Potenzial oder auf gleichem Potenzial liegen. Die zweiten Anschlüsse mögen im Wesentlichen direkt miteinander verbunden sein, so dass zwischen den zweiten Anschlüssen im Wesentlichen keine weiteren Bauelemente mehr angeschlossen sind.

Gemäß einem Ausführungsbeispiel der vorliegenden Erfindung ist das gemeinsame Potenzial ein Massepotenzial. Die zweiten Anschlüsse der passiven Bauelemente mögen in diesem Fall als Masseanschlüsse bezeichnet werden.

Das Massepotenzial mag ein Bezugspotenzial oder ein Erdpotenzial sein, welches für die gesamte Abtastvorrichtung definiert ist und welches für alle Komponenten der Abtastvorrichtung genutzt werden kann. Das direkte Verbinden des positiven Abtastanschlusses bzw. des negativen Abtastanschlusses über ein passives Bauelement direkt mit Massepotential kann Vorspannungen vermeiden und zu einem Ladungsabfluss einer an dem positiven Abtastanschluss und/oder negativen Abtastanschluss vorhandenen Ladung genutzt werden. In anderen Worten mag das Verbinden der Anschlüsse der passiven Bauelemente zu einem Ladungsausgleich von Ladungen auf den Abtastanschlüssen führen und verhindern, dass solche Ladungen unterschiedlicher Polarität über eine längere Zeit oder statisch vorhanden bleiben.

Gemäß einem weiteren exemplarischen Ausführungsbeispiel der vorliegenden Erfindung mag zumindest eine Diode aus einem Brückenzweig von zumindest zwei Dioden gebildet werden, die in Reihe oder in Serie geschaltet sind. In anderen Worten mag eine einzige vorhandene Diode durch zumindest zwei Dioden ersetzt werden, so dass ein Brückenzweig beispielsweise drei, vier oder eine Vielzahl in Reihe geschalteter Dioden aufweisen kann. In einem Beispiel mag die Anzahl der pro Brückenzweig verwendeten Dioden gerade sein. Durch die Erhöhung der Anzahl der Dioden und der damit verbundenen Reihenschaltung ihrer Schwellenspannungen mag ein hohes Eingangssignal zu verarbeiten sein.

Gemäß noch einem weiteren exemplarischen Ausführungsbeispiel der vorliegenden Erfindung ist an dem Ausgangsanschluss ein Kondensator angeschlossen. Ein Anschluss des Kondensators mag mit dem gemeinsamen Bezugspotenzial, beispielsweise dem Massepotenzial, verbunden sein und der andere Anschluss des Kondensators mag mit dem Ausgangsanschluss oder dem empfindlichen Punkt der Abtastschaltung verbunden sein.

Der Kondensator oder Ladekondensator kann die im Wesentlichen gleichspannungsfrei bereitgestellte Ausgangsspannung zusätzlich stabilisieren jedoch mag der Kondensator im Wesentlichen nicht als Filter zum Entfernen von Wechselanteilen genutzt werden. Die Ladungen, die auf dem Kondensator gespeichert werden, mögen sehr gering sein und zur Weiterverarbeitung einer hohen Verstärkung bedürfen. Der Kondensator mag als Halteglied genutzt werden. D.h. während des Abtastvorgangs, also während die Abtastbrücke leitend ist, kann Ladung vom Eingang der Abtastbrücke über die durchgeschalteten Dioden auf den Haltekondensator fließen. Nach dem Abtastvorgang, wenn die Dioden in der Brücke wieder gesperrt sind, mag die Ladung im Wesentlichen auf dem Kondensator bis zum nächsten Abtastzeitpunkt erhalten bleiben. In dieser Zeit mag der Spannungsabfall über dem Haltekondensator weiterverarbeitet oder erfasst werden.

Gemäß noch einem anderen exemplarischen Ausführungsbeispiel der vorliegenden Erfindung ist an dem Ausgangsanschluss ein Differenzverstärker angeschlossen.

Der Differenzverstärker mag an einem Vorverstärker angeschlossen sein. Der Differenzverstärker mag einen Teil einer Regeleinrichtung bilden, die zum Ausgleichen einer dem Ausgangssignal überlagerten Gleichspannung genutzt wird.

Allgemein mag als Anschluss eine Anschlussklemme bezeichnet sein. Ein Anschluss mag eine Vorrichtung zum Anschließen eines elektronischen Bauteils oder einer anderen Vorrichtung sein.

Gemäß noch einem anderen exemplarischen Ausführungsbeispiel der vorliegenden Erfindung mag an dem Ausgangsanschluss eine Regeleinrichtung vorhanden sein, welche es ermöglichen mag, eine Offsetspannung in dem Ausgangssignal zu entfernen oder zu kompensieren. Die Regeleinrichtung mag insbesondere an dem Differenzverstärker angeschlossen sein, so dass der Verstärker und/oder der Differenzverstärker zwischen dem Ausgangsanschluss der Abtastbrücke und der Regelschaltung liegen mag.

Die Regeleinrichtung mag als eine automatische Offsetiegeleinrichtung ausgebildet sein, die das Ausschalten des Senders nutzt, um den aktuellen Offsetwert oder Störwert zu bestimmen und auszugleichen. Die Regeleinrichtung mag zum Bestimmen des Offsets in vorgebbaren Zeitbereichen den Sender oder die Sende-/Empfangseinrichtung eines Messgeräts abschalten. Der Ausgleich des Offsetwerts in der Regeleinrichtung mag durch Rückführung einer Stellgröße und / oder durch digitale Verrechnung in einer digitalen Signalverarbeitungseinrichtung erfolgen.

Gemäß einem weiteren exemplarischen Ausfuhmngsbeispiel der vorliegenden Erfindung weist die Regeleinrichtung einen Digital/Analogwandler (D/A Wandler), einen Analog/Digitalwandler (A/D Wandler) und/oder ein digitales Potentiometer auf.

Gemäß noch einem anderen exemplarischen Ausführungsbeispiel der vorliegenden Erfindung weist die Abtastvorrichtung eine weitere Abtastbrücke auf.

Durch das Vorsehen einer weiteren Abtastbrücke können beispielsweise thermische Effekte, welche auf die zumindest zwei Abtastvorrichtungen im Wesentlichen gleichartig wirken, ausgeglichen werden. Die zweite Abtastbrücke mag in Ergänzung zu oder alternativ zu der Regeleinrichtung zur Elimination einer überlagerten Gleichspannung im Ausgangssignal dienen, d.h. zur Elimination eines Offsets im Ausgangssignal. Der Offset mag im Wesentlichen durch eine Asymmetrie in den Abtastsignalen verursacht werden und kann durch die zweite Brücke ausgeglichen werden. Dieser Ausgleich geschieht auch über Temperatur, da beide Abtastbrücken im Wesentlichen gleich aufgebaut sind und sich über Temperatur auch im Wesentlichen gleich verhalten.

Gemäß noch einem anderen exemplarischen Ausführungsbeispiel der vorliegenden Erfindung sind die Dioden der Abtastbrücke Scliottky-Dioden.

Ein computerlesbares Speichermedium mag eine Floppy Disk, eine Festplatte, ein USB (Universal Serial Bus) Speichermedium, ein RAM (Random Access Memory), ein ROM (Read Only Memory) oder ein EPROM (Erasable Programmable Read Only Memory) sein. Bei einem computerlesbaren Speichermedium kann es sich auch um ein Kommunikationsnetzwerk handeln, wie beispielsweise das Internet, weiches das Herunterladen eines Programmcodes erlaubt.

Es soll angemerkt werden, dass unterschiedliche Aspekte der Erfindung mit Bezug auf unterschiedliche Gegenstände beschrieben wurden. Insbesondere wurden einige Aspekte mit Bezug auf Vorrichtungsansprüche beschrieben, wohingegen andere Aspekte in Bezug auf Verfahrensansprüche beschrieben wurden. Ein Fachmann kann jedoch der vorangehenden Beschreibung und der folgenden Beschreibung entnehmen, dass, außer es wird anders beschrieben, zusätzlich zu jeder Kombination von Merkmalen, die zu einer Kategorie von Gegenständen gehört, auch jede Kombination zwischen Merkmalen als von diesem Text offenbart angesehen wird, die sich auf unterschiedliche Kategorien von Gegenständen bezieht. Insbesondere sollen Kombinationen zwischen Merkmalen von Vorrichtungsanspmchen und Merkmalen von Verfahrensansprachen offenbart sein.

### Kurze Beschreibung der Figuren

Im Folgenden werden weitere exemplarische Ausführungsbeispiele der vorliegenden Erfindung mit Verweis auf die Figuren beschrieben.
Fig. 1 zeigt ein Blockschaltbild einer Anordnung zum Abtasten eines Signals mit einer Abtastbrücke bei einer vorhandenen Vorspannung zum besseren Verständnis der vorliegenden Erfindung.
Fig. 2 zeigt ein Blockschaltbild einer Anordnung zum Abtasten eines Signals mit einer symmetrischen Abtastbrücke mit gemeinsamem Bezugspotenzial gemäß einem Ausfuhmngsbeispiel der vorliegenden Erfindung.
Fig. 2a zeigt ein Blockschaltbild einer Anordnung zum Abtasten eines Signals mit einer weiteren symmetrischen Abtastbrücke mit gemeinsamem Bezugspotenzial gemäß einem Ausführungsbeispiel der vorliegenden Erfindung.
Fig. 3 zeigt ein Blockschaltbild einer Anordnung zum Abtasten eines Signals mit einer Abtastbrücke mit gemeinsamem Bezugspotenzial und gekoppelten Dioden gemäß einem Ausfuhmngsbeispiel der vorliegenden Erfindung.
Fig. 4 zeigt ein Blockschaltbild einer Anordnung zum Abtasten eines Signals mit einer Abtastbrücke mit gemeinsamem Bezugspotenzial und ausgangsseitigem Differenzverstärker gemäß einem Ausfiihrungsboispiel der vorliegenden Erfindung.
Fig. 5 zeigt ein Blockschaltbild einer Anordnung zum Abtasten eines Signals mit einer Abtastbrücke mit gemeinsamem Bezugspotenzial und ausgangsseitiger Regelschaltung gemäß einem Ausführungsbeispiel der vorliegenden Erfindung.
Fig. 6 zeigt ein Blockschaltbild einer Anordnung zum Abtasten eines Signals mit einer gedoppelten Abtastbrücke mit gemeinsamem Bezugspotenzial gemäß einem Ausführungsbeispiel der vorliegenden Erfindung.
Fig. 7 zeigt ein Blockschaltbild eines Messgeräts mit einer Abtastvorrichtung gemäß einem Ausführungsbeispiel der vorliegenden Erfindung.
Fig. 8 zeigt ein Flussdiagramm eines Verfahrens zum Abtasten eines Signals mit einer Abtastvorrichtung gemäß einem Ausführungsbeispiel der vorliegenden

### Erfindung.

Fig. 9 zeigt ein Blockschaltbild einer Anordnung zum Abtasten eines Signals mit einer unsymmetrischen Abtastbrücke gemäß einem Ausführungsbeispiel der vorliegenden Erfindung.

### Detaillierte Beschreibung von Ausführungsbeispielen

Die Abtastvorrichtung mag als eine Anordnung zum Abtasten eines Signals oder als Abtastschaltung realisiert sein, die eine Abtastbrücke aufweist.

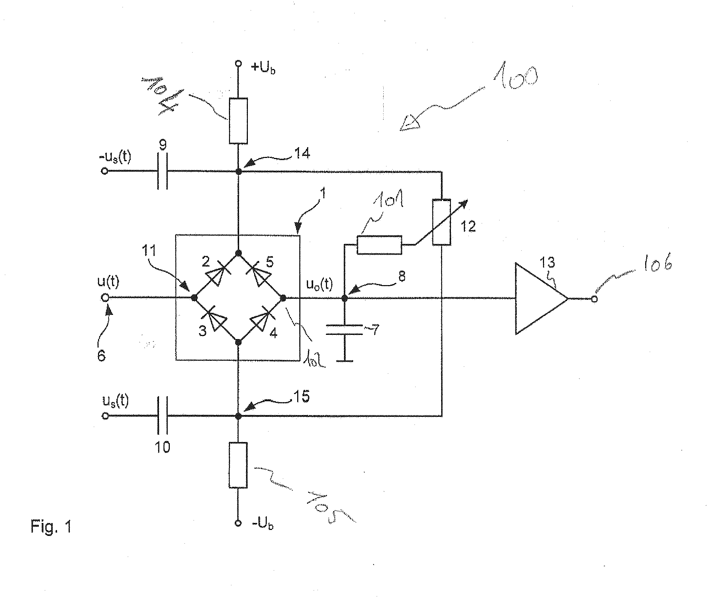

Die Darstellungen in den Figuren sind schematisch und nicht maßstäblich. In der folgenden Beschreibung der Fig.1 bis Fig. 9 werden die gleichen Bezugsziffern für gleiche oder sich entsprechende Elemente verwendet.

Fig. 1 zeigt ein Blockschaltbild einer Anordnung zum Abtasten eines Signals mit einer Abtastbrücke bei einer vorhandenen Vorspannung zum besseren Verständnis der vorliegenden Erfindung. In Fig. 1 ist eine Abtastschaltung 100 mit einer symmetrischen Diodenbrücke 1 oder symmetrischen Abtastbrücke 1 dargestellt, aufweisend insgesamt vier Schaltdioden 2, 3, 4, 5. Die vier Dioden 2, 3, 4, 5 sind im Ruhezustand der Schaltung zwischen den Abtastzeitpunkten durch die betragsmäßig im Wesentlichen identischen Spannungen unterschiedlicher Polarität +U_{b} und -U_{b} über Widerstände 104,105 negativ vorgespannt und folglich gesperrt. Wegen der Vorspannung liegen die passiven Bauelemente 104, 105 auf einem Potenzial, das sich von dem Bezugspotenzial unterscheidet. Die Vorspannung in Sperrrichtung der Dioden der Abtastbrücke 1 kann im Wesentlichen verhindern, dass ein eventuell anstehendes Eingangssignal, das in Fig. 1 als ein von der Zeit t abhängiges Eingangssignal u(t) dargestellt ist, die Schaltdioden 2, 3 in den leitenden Zustand versetzen kann. Das zeitabhängige Signal u(t) kann ein Wechselstromsignal (AC) sein. Unter einem Wechselstromsignal kann ein sinusförmiges Signal verstanden werden, es muss sich aber nicht notwendigerweise um ein sinusförmiges Signal handeln. Vielmehr ist die sequentielle Abtastung für jedes beliebige periodische Eingangssignal u(t) geeignet.

Zum Zeitpunkt der Abtastung versetzen die impulsförmigen Abtastsignale oder impulsförmigen Samplingsignale, die in Fig. 1 als zeitabhängiges positives Abtastsignal uₛ(t) und als zeitabhängiges negatives Abtastsignal -uₛ(t) dargestellt sind, die Schaltdioden 2, 3, 4, 5 in den leitenden Zustand. Das positive Abtastsignale uₛ(t) und das negatives Abtastsignal -uₛ(t) mögen im Wesentlichen dem Betrag nach gleiche Signale mit umgekehrten Vorzeichen sein. Die Verbindung zwischen der Eingangsklemme 6 und einem Ladekondensator 7 oder dem Ausgangsanschluss 102, durch die Abtastbrücke 1 wird niederohmig, so dass der Kondensator 7 durch die Eingangsspannung u(t) geladen oder entladen werden kann. Nach dem Abtastvorgang sperren die Dioden 2, 3, 4, 5 wieder und die Ladung auf dem Kondensator 7 bleibt näherungsweise bis zum nächsten Abtastzeitpunkt erhalten. Die Ausgangsspannung uₒ(t) ergibt sich als zeitlich mittlerer Spannungsabfall am Ladekondensator 7 und lässt sich am Schaltungsknoten 8 abgreifen.

### Das Eingangssignal u(t) und das Ausgangssignal uₒ(t) oder die Ausgangsspannung uₒ(t) an der Abtastbrücke 1 sind periodische Signale

Die beiden impulsförmigen Abtastsignale uₛ(t) und -uₛ(t) werden über zwei Kondensatoren 9, 10 zugeführt, die zur DC-Entkopplung dienen. Die DC-Entkopplung blockiert im Wesentlichen einen Gleichstrom (DC). Bezogen auf das Massepotential sind die beiden Abtastsignale betragsmäßig im Wesentlichen identisch und zueinander invers, d.h. sie liegen mit unterschiedlicher Polarität vor. Die Erzeugung dieser Signale erfolgt beispielsweise durch ein Symmetrierglied (Balun), welches in Fig. 1 nicht dargestellt ist. Durch die vorliegende Symmetrie in der Schaltung löschen sich die beiden Abtastsignale uₛ(t) und -uₛ(t) im Wesentlichen an den Schaltungsknoten 8 und 11 aus, d.h. der Abtasttakt ist vom Eingang bzw. Ausgang der Schaltung im Wesentlichen isoliert.

Das Isolieren des Taktsignals vom Ausgang mag helfen, dass das Taktsignal uₛ(t) und -uₛ(t) am Ausgang der Schaltung 1 nicht messbar ist, obwohl es in der Schaltung 1 verwendet wird, beispielsweise um die Dioden durchzuschalten. Die Isolierung kann z.B. durch geeignete schaltungstechnische Maßnahmen realisiert werden. In dem Ausführungsbeispiel nach Fig. 1 wird das Taktsignal durch Auslöschung der beiden symmetrischen Komponenten uₛ(t) und -uₛ(t) am Ausgang 8 bzw. Eingang 11 eliminiert.

Mit der Abtastschaltung 100 aus Fig. 1 wird ein im Wesentlichen gleichspannungsfreies bzw. offsetfreies Ausgangssignal uₒ(t) am Schaltungsknoten 8 und an dem Ausgangsanschluss 102 der Abtastbrücke 1 erzeugt. Der Schaltungsknoten 8 und der Ausgangsanschluss 102 sind miteinander verbunden. Voraussetzung für die Erzeugung des gleichspannungsfreien bzw. offsetfreien Ausgangssignals am Schaltungsknoten 8 ist wiederum die im Wesentlichen vorhandene Schaltungssymmetrie der Abtastbrücke selbst bzw. die Symmetrie der beiden Abtastsignale oder Taktsignale uₛ(t) und -uₛ(t). In einer tatsächlich realisierten Schaltung mag es jedoch aufgrund von Toleranzen und parasitären Elementen der verwendeten Bauteile der Abtastvorrichtung schwierig sein, vollständig symmetrische Abtastsignale uₛ(t) und -uₛ(t) zu erzeugen. Ferner kann es durch Bauteiltoleranzen, z.B. in den Schaltdioden 2, 3, 4, 5, zu einem Ungleichgewicht in der Abtastbrücke 1 kommen. Beide Effekte, Asymmetrien in den Abtastsignalen und / oder in den Bauelementen, resultieren in einer Asymmetrie der Abtastung und äußern sich u.a. durch eine dem Ausgangssignal uₒ(t) überlagerte Gleichspannung (DC-Symmetrie) und durch unterschiedliche Signalamplituden des Ausgangssignals uₒ(t) je nach Polarität des Eingangssignals u(t) (AC-Symmetrie). Die dem Ausgangssignal uₒ(t) überlagerte Gleichspannung (DC-Symmetrie) oder OffsetSpannung ist folglich in einem Aufbau mit Unsymmetrien auch vorhanden, wenn nur der Abtasttakt uₛ(t) und -uₛ(t) anliegt, jedoch kein Eingangssignal u(t).

Mit Hilfe des Potentiometers 12 wird am Ausgang 8 der Abtastbrücke 1 eine Spannung eingespeist, die der ungewollte Gleichspannung oder dem Offset aufgrund von mangelnder Symmetrie entgegenwirkt, die dem Ausgangssignal uₒ(t) überlagert ist, diese ausgleicht und somit die Symmetrie der Abtastung ein wenig verbessern kann. Das Potentiometer 12 wird manuell eingestellt und wird in regelmäßigen Zeitabständen manuell an die gerade vorliegende ungewollte Gleichspannung angepasst. Bei der in Fig. 1 dargestellten Schaltungsrealisierung findet der Eingriff am Ausgangsknoten 8 unmittelbar vor dem Zwischenfrequenzverstärker 13 statt und kann zu starken Auswirkungen hinter dem Zwischenfrequenzverstärker 13 an dem Ausgang 106 führen. Der Ausgangsknoten 8 stellt den empfindlichsten Punkt der Abtastvorrichtung 100 dar. Diese Stelle 8 der Abtastvorrichtung ist anfällig für die Einstrahlung von Störsignalen z.B. durch Übersprechen. Die Einspeisung einer Gleichspannung am Ausgang 8 unmittelbar vor dem Zwischenfrequenzverstärker 13 kann zu einer Verschlechterung der Signalintegrität führen.

In anderen Worten kann mit dem Potentiometer 12 der Geleichspannungs-Offset oder DC-Offset des abgetasteten Signals verändert werden. Im Verstärker 13 wird das abgetastete Signal noch verstärkt bevor es weiterverarbeitet wird. Nicht ausgeglichene Offset Anteile werden ebenfalls verstärkt und können aufgrund des hohen Verstärkungsfaktors des Verstärkers 13 starke Auswirkungen auf die Weiterverarbeitung des abgetasteten Signals haben.

Es können auch mehrere Abtastschaltungen 100 vorhanden sein, bei welchen ausschließlich Feldeffekttransistoren und nicht Dioden als nichtlineare Schaltelemente verwendet werden. Diese Lösung ist technisch realisierbar. Es ist jedoch zu beachten, dass Feldeffekttransistoren, die für den höheren Mikrowellenbereich geeignet sind, im Allgemeinen sehr teuer sind und beispielsweise die Kosten für Hochfrequenzdioden übersteigen können, die ebenfalls in diesem Frequenzbereich einsetzbar sind.

In Fig. 1 wurde eine Schaltung 100 angegeben, um die in der Realität im Wesentlichen immer auftretende A symmetrie der Abtastung zu kompensieren. Die Kompensation wird mit dem Widerstand 101 durchgeführt, der mit dem Schleifkontakt eines Potentiometers 12 und dem Ausgangsknoten 8 verbunden ist. Die beiden Außenkontakte des Potentiometers 12 sind mit dem negativen Abtastanschluss 14 und dem positiven Abtastanschluss 15 verbunden. Der Ausgangsknoten 8 ist mit dem Ausgangsanschluss 102 der Abtastbrücke 1 verbunden. Dabei muss jedoch an dem Ausgangsknoten 8 der Abtastbrücke 1 eingegriffen werden. Der Ausgangsknoten 8 stellt im Wesentlichen den empfindlichsten Punkt der Schaltung dar und kann anfällig für die Einstrahlung von Störsignalen sein, z.B. durch Übersprechen. Die Einspeisung einer Gleichspannung am Ausgang 8 unmittelbar vor dem Zwischenfrequenzverstärker 13 ist daher aus Gründen der Signalintegrität in vielen Fällen nicht möglich.

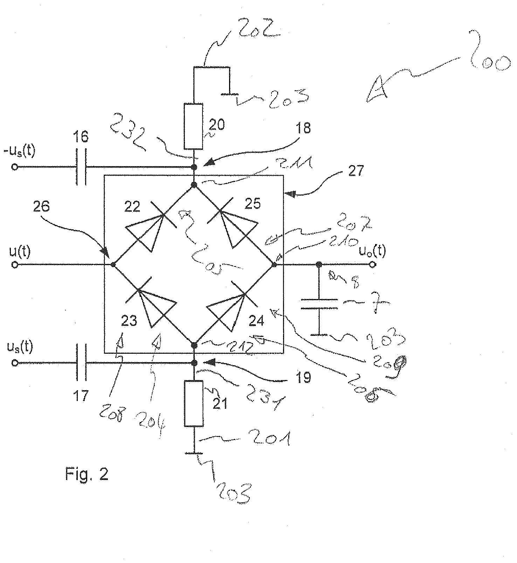

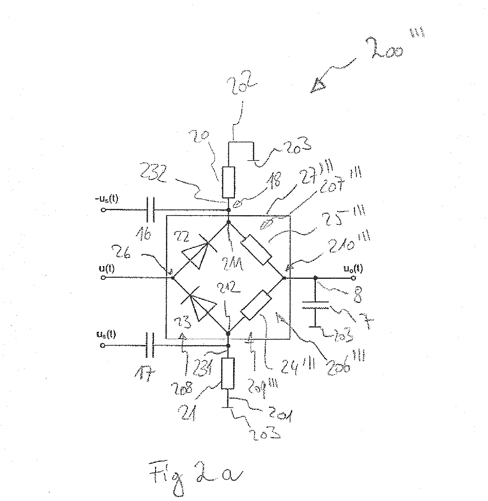

Die Fig. 2 zeigt ein Blockschaltbild einer Anordnung zum Abtasten eines Signals mit einer symmetrischen Abtastbrücke mit gemeinsamem Bezugspotenzial 203 gemäß einem Ausführungsbeispiel der vorliegenden Erfindung. Bei der Schaltungsausführung 200 aus Fig. 2 werden die Dioden 22,23,24,25 in der Abtastbrücke 27 ohne Vorspannung betrieben. Eine Einrichtung zur Offsetkorrektur ist in der Anordnung nach Fig. 2 nicht vorgesehen. Zum Betrieb ohne Vorspannung sind die zweiten Anschlüsse 201, 202 des passiven Bauelements 21 und des zweiten passiven Bauelements 20 im Wesentlichen direkt mit einem gemeinsamen Bezugspotenzial 203 verbunden. Folglich sind die zweiten Anschlüsse 201,202 direkt miteinander verbunden. Durch dieses direkte Verbinden kann die Erzeugung, Aufbereitung und Überwachung der beiden Spannungen +U_{b} und -U_{b} entfallen, die in Fig. 1 dargestellt sind. Der erste Anschluss 231 des ersten passiven Bauelementes 21 ist mit dem positiven Abtastanschluss 212 verbunden und der erste Anschluss 232 des zweiten passiven Bauelements 20 ist mit dem negativen Abtastanschluss 211 verbunden. Die Anschlüsse 202, 232, 231, 203 der passiven Bauelemente 20, 21 können Leitungsstücke sein. Die beiden passiven Bauelemente 20, 21 ermöglichen es, dass sich die Kondensatoren 16 und 17 im Ruhezustand zwischen den Abtastzeitpunkten entladen können. Die passiven Bauelemente 20, 21 können durch zwei Widerstände 20, 21 realisiert sein, die zwischen den Schaltungsknoten 18, 19 und der Schaltungsmasse 203 angeordnet sind. Ein Entfemen der Widerstände 20, 21 könnte die Funktion der Schaltung 200 beeinträchtigen. Anstatt der Widerstände 20, 21 können beispielsweise auch Induktivitäten oder Filterstrukturen eingesetzt werden. Der Schaltungsknoten 18 ist mit dem ersten Anschluss 232 des zweiten passiven Bauelements 20 und dem negativen Abtastanschluss 211 verbunden. Der Schaltungsknoten 19 ist mit dem ersten Anschluss 231 des ersten passiven Bauelements 21 verbunden.

Die Abtastbrücke 27 weist vier Abschnitte 204, 205, 206, 207 mit jeweils einer einzigen Diode 22, 23, 24, 25 auf. Je zwei in Reihe geschaltete Abschnitte bilden einen Brückenzweig 208, 209. Der erste Brückenzweig 208 wird von der Reihenschaltung der Dioden 22 und 23 gebildet, wobei die Anode der Diode 22 mit der Kathode der Diode 23 verbunden ist. Der zweite Brückenzweig 209 wird von der Reihenschaltung der Dioden 25 und 24 gebildet, wobei die Anode der Diode 25 mit der Kathode der Diode 24 verbunden ist.

Die Verbindungsstelle der Dioden 22 und 23 bildet den Eingangsanschluss 26 und die Verbindungsstelle der Dioden 25 und 24 bildet den Ausgangsanschluss 210.

An den Verbindungsstellen der Kathoden der Dioden 22 und 25 des ersten Brückenzweigs 208 bzw. des zweiten Brückenzweigs 209 wird der negative Abtastanschluss 211 ausgebildet.

An den Verbindungsstellen der Anoden der Dioden 23 und 24 des ersten Brückenzweigs 208 bzw. des zweiten Brückenzweigs 209 wird der positive Abtastanschluss 212 ausgebildet.

Über den negativen Abtastanschluss 211 wird über einen Kondensator 16 oder Trennkondensator 16 das negative Abtastsignal -uₛ(t) und über den positiven Abtastanschluss 212 wird über einen Kondensator 17 oder Trennkondensator 17 das positive Ablastsignal uₛ(t) an die Abtastbrücke 27 geführt.

Um größere Eingangssignale abtasten zu können, ohne die Dioden in der Abtastbrücke 27 negativ vorzuspannen, ist der Einsatz von mehreren in Reihe geschalteten Dioden in den einzelnen Abschnitten 204, 205, 206, 207 der Brückenzweige 208, 209 der Abtastbrücke 27 vorgesehen.

In der Abtastbrücke 27, werden kostengünstige Schottky-Dioden, 22, 23, 24, 25 als Schaltelemente eingesetzt, die aufgrund ihrer kleinen Sättigungskapazitäten speziell für Hochfrequenzanwendungen bis in den Mikrowellenbereich anwendbar sind. Die Dioden 22, 23, 24, 25 in der Abtastbrücke 27, werden nicht durch zwei Gleichspannungen +U_{b} und -U_{b} negativ vorgespannt betrieben. Die Dioden werden somit vorspannungsfrei betrieben. Das Vermeiden der positiven und der negativen Vorspannung hilft, dass die Erzeugung, Aufbereitung und Überwachung der beiden Spannungen +U_{b} und -U_{b} entfallen kann. Durch das Entfallen der Vorspannungen kann die Abtastschaltung 27 einfach aufgebaut und betrieben werden. Trotzdem ist die Abtastschaltung 200 so angepasst, stich die Kondensatoren 16 und 17 im Ruhezustand zwischen den Abtastzeitpunkten entladen können, da sie sich durch die impulsförmigen Abtastsignale uₛ(t) und -uₛ(t) und die anliegende Eingangsspannung u(t) in jeder Abtastperiode zu einem gewissen Grad aufladen. Dieses Entladen kann durch passive Bauelemente 20, 21, beispielsweise durch zwei Widerstände 20, 21 gesteuert werden, die zwischen den Schaltungsknoten 18 und 19 und der Schaltungsmasse 203 angeordnet sind. Die Bauelemente der Abtastschaltung 200 sind so dimensioniert, dass das Entladen der Kondensatoren 16 und 17 im Wesentlichen unabhängig von dem Laden oder Entladen des Kondensators 7 durch das Eingangssignal u(t) erfolgt. Bei der Dimensionierung werden die Kapazitätswerte der Kondensatoren 16 und 17 und die Werte der Widerstände 20 und 21 auf die impulsförmigen Abtastsignale abgestimmt. Bei der Dimensionierung der Bauteilwerte spielt die Amplitude, die Pulslänge und die Pulswiederholfrequenz der Abtastsignale eine große Rolle.

Eine mögliche Dimensionierung der Kondensatoren und Widerstände sieht vor, dass ein nahezu vollständiges Entladen der Kondensatoren 16 und 17 zwischen den Abtastzeitpunkten erzielt wird.

Eine weitere mögliche Dimensionierung, welche auch bei Messgeräten zum Einsatz kommt, zielt darauf ab, dass sich der Schaltungsknoten 18, an welchem die negativen Abtastpulse wirken, auf einen leicht positiven Spanungswert auflädt. Im Gegenzug dazu muss sich der Schaltungsknoten 19, an welchem die positiven Abtastpulse wirken, auf einen leicht negativen Spannungswert aufladen.

Die Ladungen auf den Kondensatoren 16 und 17 und damit die Spannungen an den Punkten 18 und 19 bleiben bei dieser weiteren Dimensionierung auch im Ruhezustand der Schaltung zwischen den Abtastzeitpunkten erhalten und wirken wie eine Vorspannung der Dioden 22,23,24 und 25 in Sperrrichtung.

Der Wahl von Kapazitäts- und Widerstandswerten sind allerdings Grenzen gesetzt. Die Kapazitätswerte, d.h. die Kondensatoren 16 und 17, werden beispielsweise so groß gewählt werden, dass sie die Abtastpulse ohne größere Verzerrungen passieren lassen.

Weiterhin müssen die Widerstände 20, 21 so groß gewählt werden, dass die Abtastsignale nicht zu sehr belastet werden und sich dadurch der Wirkungsgrad der Abtastung zu sehr verschlechtert.

Fig. 2 zeigt die Realisierung dieser Schaltungsausführung 200 mit der Abtastbrücke 27. In einer weiteren Ausführung können anstatt der Widerstände 20 und 21 beispielsweise auch Induktivitäten oder Filterstrukturen, beispielsweise Tiefpassfilter, eingesetzt werden, die eine DC-Verbindung oder Gleichstromverbindung von den Schaltungsknoten 18 und 19 zur Schaltungsmasse 203 herstellen und die Kondensatoren 16 und 17 im Ruhezustand zwischen den Abtastzeitpunkten entladen. Die Schaltungsknoten 18 und 19 können als verlängerter positiver Abtastanschluss 212 und negativer Abtastanschluss 211 betrachtet werden.

Durch das Anlegen der impulsförmigen Abtastsignale uₛ(t) und -uₛ(t) über die Trennkondensatoren 16, 17 an den negativen Abtastanschluss 211, 18 und an den positiven Abtastanschluss 212, 19, werden die Dioden 22, 23, 24, 25 der Abtastbrücke 27 leitend und verbinden im Wesentlichen, vergleichbar mit einem Kurzschluss, den Eingangsanschluss 26 und den Ausgangsanschluss 210, so dass während der Zeit des Anliegens der Abtastsignale uₛ(t) und -uₛ(t) mit einem Wert über der Schwellenspannung der Dioden das Signal u(t) als Ausgangssignal u₀(t) erscheint. Nach dem Anliegen der Abtastsignale uₛ(t) und -uₛ(t) ist die Verbindung zwischen Eingangsanschluss 26 und Ausgangsanschluss 210 im Wesentlichen wieder blockiert.

Schottky-Dioden sind für den Mikrowellenbereich in verschiedenen Ausführungen erhältlich. Sie werden u.a. nach der Höhe ihrer Schwellenspannung, die auch Flussspannung genannt wird, unterschieden. Hohe Schwellenspannungen werden bei sog. "High-Barrier-Dioden" erreicht und liegen im Bereich von 0,65 bis 0,7 V. Die fehlende negative Vorspannung der Dioden 22,23,24 und 25 kann zu störenden Einflüssen bei der Verarbeitung von großen Eingangssignalen u(t) führen.

Überschreitet das abzutastende Eingangssignal u(t) die Schwellenspannung des verwendeten Diodentyps werden die Dioden 22 oder 23 am Eingangsknoten 26 oder Eingangsanschluss 26 auch ohne anliegende Abtastsignale uₛ(t) und -uₛ(t) leitend, was die Symmetrie der Schaltung beeinträchtigen kann und die Funktionsweise der Abtastung des Signals u(t) stören kann. Um auch größere Eingangssignale u(t) abtasten zu können, ohne die Dioden 22,23, 24 und 25 in der Abtastbrücke 27 negativ vorzuspannen, ist der Einsatz von mehreren in Reihe geschalteten Dioden in den einzelnen Zweigen der Abtastbrücke 27 vorgesehen.

Fig. 2a zeigt ein Blockschaltbild einer Anordnung 200"' zum Abtasten eines Signals mit einer weiteren symmetrischen Abtastbrücke mit gemeinsamem Bezugspotenzial gemäß einem Ausführungsbeispiel der vorliegenden Erfindung. Die Abtastbrücke 27"' weist im Vergleich zu der Abtastbrück 27 aus Fig. 2 die passiven Brückenbauelemente 24"', 25"' in dem Brückenzweig 209"' auf. Die Brückenbauelemente 24"', 25"' sind in den Abschnitten 206"', 207"' des Brückenzweigs 209"' enthalten. Die weitere Abtastbrücke 27"' oder die weitere Abtastvorrichtung 27"' entspricht im Wesesentlichen der Abtastbrücke 27 aus Fig. 2, wobei sich der Zweig 209 von dem Zweig 209"' darin unterscheidet, dass der Zweig 209"' passive Brückenbauelemente 24"', 25"' aufweist, die in dem Zweig 209 als seriell geschaltete Dioden 24, 25 realisiert sind. Der Aufbau der weiteren Abtastbrücke 27"' ist im Wesentlichen symmetrisch. Der Ausgangsanschluss 210"' entspricht im Wesentlichen dem Ausgangsanschluss 210.

Die symmetrischen Abtastbrücken 27, 28, 27"' mögen Abtastbrücken mit im Wesentlichen symmetrisch angeordneten Bauelementen sein. Trotz der symmetrisch angeordneten Bauelemente kann es zu Asymmetrien oder Unsymmetrien bei den elektrischen Eigenschaften kommen, die zu Gleichspannungs-Offsets führen können.

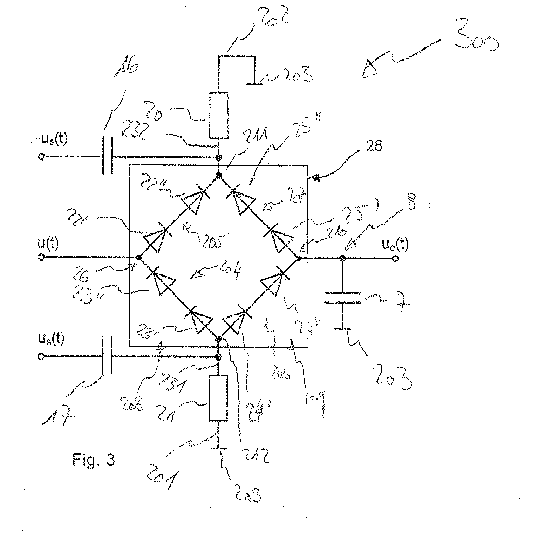

In Fig. 3 ist ein Ausführungsbeispiel mit jeweils zwei in Reihe geschalteten Dioden 22', 22", 23', 23", 24', 24", 25', 25" je Zweig in der Abtastbrücke 28 dargestellt. Bei einer solchen Anordnung mit jeweils gedoppelten Dioden 22', 22" ist das Eingangssignal u(t) maximal im Wesentlichen auf die doppelte Schwellenspannung des eingesetzten Diodentyps begrenzt.

Fig. 3 zeigt ein Blockschaltbild einer Anordnung 300 zum Abtasten eines Signals mit einer Abtastbrücke 28 mit gemeinsamem Bezugspotenzial und gedoppelten Dioden gemäß einem Ausführungsbeispiel der vorliegenden Erfindung. In Fig. 3 ist somit ein Ausführungsbeispiel der Schaltung der Fig. 2 mit zwei in Reihe geschalteten Dioden je Abschnitt 204, 205, 206, 207 des ersten Zweigs 208 bzw. des zweiten Zweigs in der Abtastbrücke 28 dargestellt. Hier ist das Eingangssignal im Wesentlichen maximal auf die doppelte Schwellenspannung des eingesetzten Diodentyps begrenzt. Die Diode 22 mit der einfachen Schwellenspannung ist durch die beiden Dioden 22' und 22" mit der jeweils einfachen Schwellenspannung ersetzt, die sich zu der doppelten Schwellenspannung im Abschnitt 205 addieren. Die Diode 23 mit der einfachen Schwellenspannung ist durch die beiden Dioden 23' und 23" mit der jeweils einfachen Schwellenspannung ersetzt, die sich zu der doppelten Schwellenspannung im Abschnitt 204 addieren. Die Diode 25 mit der einfachen Schwellenspannung ist durch die beiden Dioden 25' und 25" mit der jeweils einfachen Schwellenspannung ersetzt, die sich zu der doppelten Schwellenspannung im Abschnitt 207 addieren. Die Diode 24 mit der einfachen Schwellenspannung ist durch die beiden Dioden 24' und 24" mit der jeweils einfachen Schwellenspannung ersetzt, die sich zu der doppelten Schwellenspannung im Abschnitt 206 addieren.

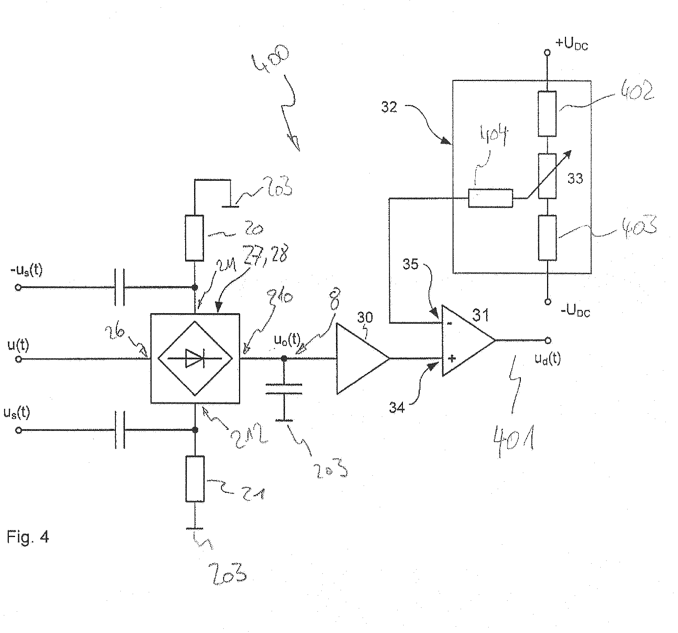

Fig. 4 zeigt ein Blockschaltbild einer Anordnung zum Abtasten eines Signals mit einer Abtastbrücke 27, 28 mit gemeinsamem Bezugspotenzial 203 und ausgangsseitigem Diffierenzenverstärker 31 gemäß einem Ausführungsbeispiel der vorliegenden Erfindung. Bei der Abtastbrücke 27, 28 in Fig. 4 kann es sich um eine symmetrische oder um eine unsymmetrische Brücke handeln. In Fig. 4 ist eine Abtastschaltung 400 angegeben, die auf den Eingriff am im Wesentlichen empfindlichsten Punkt 8 der Schaltung am Ausgang 210 der Abtastbrücke 27, 28 im Wesentlichen verzichtet und damit die Störfestigkeit der Anordnung verbessern kann. Das abzutastende Signal u(t) wird der Abtastbrücke 27, 28 an dem Eingangsanschluss 26 zugeführt. Trotz dem Verzicht auf den Eingriff an dem empfindlichen Punkt 8, also trotz dem Verzicht auf das direkte Einwirken auf das abgetastete Signal uₒ(t), vermag die Schaltung 400 die dem Ausgangssignal uₒ(t) überlagerte Gleichspannung auszugleichen. In anderen Worten mag ein Eingriff erst hinter dem Verstärker 30 erfolgen. Das abgetastete Signal uₒ(t) oder das Ausgangssignal uₒ(t) wird an der Ausgangsklemme 210 der Abtastbrücke 27, 28 bereitgestellt. Von dort gelangt das abgetastete Signal auf den Verstärker 30, der im Wesentlichen den Ausgang 401 von dem empfindlichen Punkt 8 isoliert und das unter Umständen kleine Ausgangssignal uₒ(t) verstärkt. Der Ausgleich von der dem Ausgangssignal uₒ(t) überlagerten Gleichspannung wird durch einen zweiten Verstärker 31 durchgeführt, der als Differenzverstärker ausgebildet ist und in einer Signalflussrichtung nach dem ersten Zwischenfrequenzverstärker 30 angeordnet ist. Der Differenzverstärker 31 liegt näher an dem Ausgang 401 als der Zwischenfrequenzverstärker 30.

In Fig. 4 ist folglich eine Schaltung 400 angegeben, die auf den Eingriff an dem empfindlichen Punkt 8 der Schaltung unmittelbar vor dem ersten Zwischenfrequenzverstärker 30 verzichtet und trotzdem die dem Ausgangssignal uₒ(t) überlagerte Gleichspannung auszugleichen vermag. In anderen Worten bedeutet das Ausgleichen der überlagerten Gleichspannung eine Offsetkorrektur. Zu dem Ausgleich der Gleichspannung wird ein zweiter Verstärker 31 genutzt, der als Differenzverstärker ausgeführt ist und in einer Signalausbreitungsrichtung nach dem ersten Zwischenfrequenzverstärker 30 angeordnet ist. Das Ausgangssignal uₒ(t) der Abtastbrücke 27, 28 wird zunächst mit der unerwünschten überlagerten Gleichspannung dem ersten ZF-Verstärker 30 (Zwischenfrequenzverstärker 30) zugeführt und verstärkt. In einem zweiten Schritt wird das Signal einem positiven Eingang 34 des Differenzverstärkers 31 zugeführt. Am zweiten Eingang 35 des Differenzverstärkers wird eine Gleichspannung zugeführt, die z.B., wie in Fig. 4 zu sehen ist, über einen Spannungsteiler 32 und einen Widerstand 404 mit dem Potentiometer 33 in gewissen Grenzen einstellbar ist. Der Spannungsteiler 32 weist auch die beiden Teilungswiderstände 402, 403 auf. Auch bei der Anordnung 400 ist eine manuelle Einstellung und eine manuelle Nachführung der Ausgleichsspannung nötig. Der Differenzverstärker 31 bildet eine gewichtete Differenz der Signale an seinen beiden Eingängen 34 und 35 und erzeugt am Ausgang 401 ein Ausgangssignal u_{d}(t). Folglich ist es möglich, die dem Ausgangssignal uₒ(t) überlagerte Gleichspannung auszugleichen und ein gleichspannungsfreies Ausgangssignal u_{d}(t) zu erzeugen.

Weiterhin kann mit der Schaltungsanordnung aus Fig. 4 dem Ausgangssignal u_{d}(t) des Differenzverstärkers 31 bewusst ein definierter Gleichspannungsanteil überlagert werden. Bei der Abtastbrücke 27, 28 kann es sich um eine symmetrisch aufgebaute Abtastbrücke 27, 28 handeln. Der Ausgang uₒ(t) kann aber auch ein Ausgang einer unsymmetrisch aufgebauten Abtastbrücke sein.

Es ist jedoch mit der Anordnung aus Fig. 4 im Wesentlichen nicht möglich, die in der Realität oft auftretende Asymmetrie der Abtastung zu beeinflussen. Diese Asymmetrie kann durch nicht ideale Baut-eile verursacht werden. Nicht ideale Bauteile sind durch Toleranzen und parasitäre Elemente beeinträchtigt. Durch die Verschaltung nach Fig. 4, insbesondere durch die Anordnung von Verstärker 30 und Differenzverstärker 31, kann die Auswirkung der erzeugten Asymmetrie ausgeglichen werden, also kann der Gleichspannungsoffset ausgeglichen werden. Die auftretende Asymmetrie der Abtastung kann bei dem Aufbau der Abtastbrücke 27, 28 nach Fig. 4 und durch sorgfältige Auswahl der Bauelemente der Schaltungsanordnung 400, insbesondere der Schaltdioden in der Abtastbrücke 27,28 und des Symmetriergliedes (nicht gezeigt in Fig. 4) zur Erzeugung der Abtastsignale uₛ(t) und -uₛ(t), in vertretbaren Grenzen gehalten werden und für Anwendungen in der Füllstandmesstechnik genutzt werden.

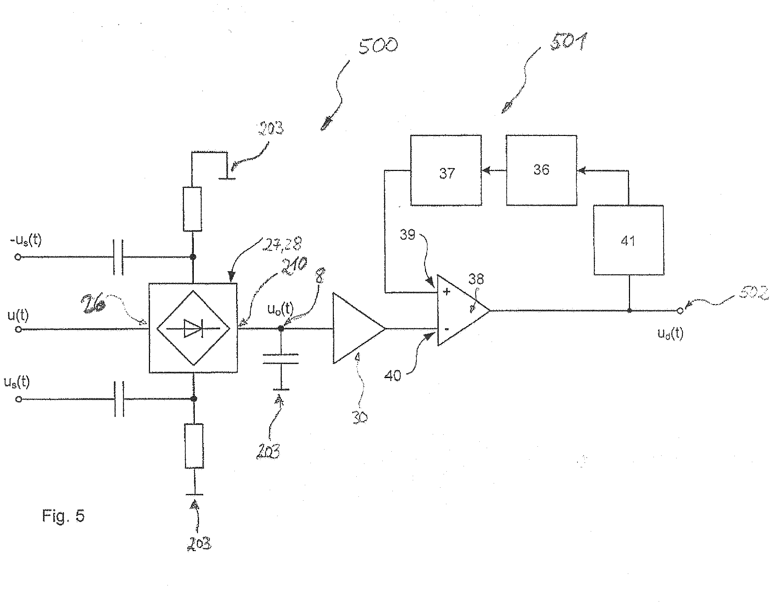

Fig. 5 zeigt ein Blockschaltbild einer Anordnung 500 zum Abtasten eines Signals mit einer Abtastbrücke 27, 28 mit gemeinsamem Bezugspotenzial 203 und ausgangsseitiger Regelschaltung 501 gemäß einem Ausführungsbeispiel der vorliegenden Erfindung. Bei der Abtastbrücke 27, 28 kann es sich um eine symmetrisch aufgebaute Abtastbrücke 27, 28 handeln. Der Ausgang u₀(t) kann aber auch ein Ausgang einer unsymmetrisch aufgebauten Abtastbrücke sein. In Fig. 5 ist eine Abtastschaltung 500 angegeben, die ein im Wesentlichen gleichspannungsfreies Ausgangssignal u_{d}(t) an dem Differenzenverstärker 38 automatisiert mit Hilfe einer Regeleinrichtung 501 erzeugt. Diese Schaltung 500 kann gut bei wechselnden Umgebungstemperaturen in einem großen Temperaturbereich eingesetzt werden. Alternativ kann das Ausgangssignal u_{d}(t) auch definiert mit einer Gleichspannung überlagert werden.

Die Regeleinrichtung 501 weist die Recheneinheit 36 oder den Prozessor 36, den Analog-Digital-Wandler 41 (A/D Wandler), den Digital-Analog-Wandler 37 (D/A-Wandler) und den Differenzenverstärker 38 auf. Das Ausgangssignal u_{d}(t) des Differenzenverstärkers 38 wird über den A/D Wandler 41, die Recheneinheit 36 und den D/A-Wandler 37 an den positiven Eingang 39 des Differenzenverstärkers 38 zurückgeführt. In der Recheneinheit 36 oder der Offsetbestimmvorrichtung 36 wird mit Hilfe des Ausschaltens einer Sendeeinrichtung oder einer Sende-/Empfangseinrichtung eines Messgeräts (nicht in Fig. 5 dargestellt) ein Offset während einer künstlich erzeugten Ruhephase ermittelt. Mit diesem im Wesentlichen in dem Moment der Ermittlung vorhandenen Offsetwert kann der störende Offset zeitnah ausgeglichen werden. Ein manueller Eingriff zum Ausgleichen des Offsets, wie bei dem Nachstellen des Potentiometers 33 mag durch den automatischen Offsetausgleich mittels Regelschaltung 501 vermeidbar sein.

Über den negativen Eingang 40 des Differenzenverstärkers 38 wird dem Differenzenverstärker 38 über einen Verstärker 30 das Ausgangssignal u₀(t) zugeführt. Die Automatische Regelungsschleiie 501 oder die Regeleinrichtung 501 ersetzt die manuelle Gleichstromausgleichseinrichtung 32 der Fig. 4.

Wie beschrieben kann in der Regeleinrichtung 501 die Erzeugung eines im Wesentlichen gleichspannungsfreien Ausgangssignals u_{d}(t) oder die definierte Überlagerung des Ausgangssignals u_{d}(t) mit einem Gleichanteil als Alternative zu der manuellen Einstellung mit Potentiometern 12, 33 automatisiert erfolgen. Im Detail entnimmt die Regeleinrichtung 501 das Ausgangssignal U_{d}(t) und erzeugt daraus eine Stellgröße in Form einer Spannung für den Differenzverstärker 38. Dieses abgezweigte Ausgangssignal U_{d}(t) wird über einen A/D-Wandler 41 beispielsweise der Recheneinheit 36 zugeführt, welche das Signal auf einen Gleichspailnungsanteil überprüft, indem die Recheneinheit 36 das digitalisierte Signal u_{d}(t) mit einem Referenzwert vergleicht. Die Recheneinheit 36 wiederum steuert den Digital-Analog-Wandler 37 an, der eine Ausgangsspannung erzeugt, die dem positiven Eingang 39 des Differenzverstärkers 38 zugeführt wird und den Gleichspannungsanteil des Signals u_{d}(t) auszugleichen vermag, so dass ein gleichanteilfreies Ausgangssignal u_{d}(t) entsteht. Bei diesem Vorgehen wird der Offset von u_{d}(t) korrigiert. Der bereits im Signal uₒt) vorhandene Gleichspannungsanteil kann durch die Regeleinrichtung 501 im Wesentlichen nicht beeinflusst werden. Insbesondere über die Veränderung der Temperatur wird sich der Gleichspannungsanteil des Ausgangssignals uₒ(t) der Abtastbrücke 27, 28 ändern und kann mit Hilfe der beschriebenen Regeleinrichtung 501 kompensiert werden, so dass über dem gesamten relevanten Temperaturbereich, in dem die Schaltung 500 betrieben wird, ein im Wesentlichen gleichspannungsfreies Ausgangssignal u_{d}(t) am Ausgang 502 vorliegt.

Anstatt eines Digital-Analog-Wandlers 37 kann beispielsweise auch ein digitales Potentiometer zum Einsatz kommen, welches von der Recheneinheit 36 angesteuert wird.

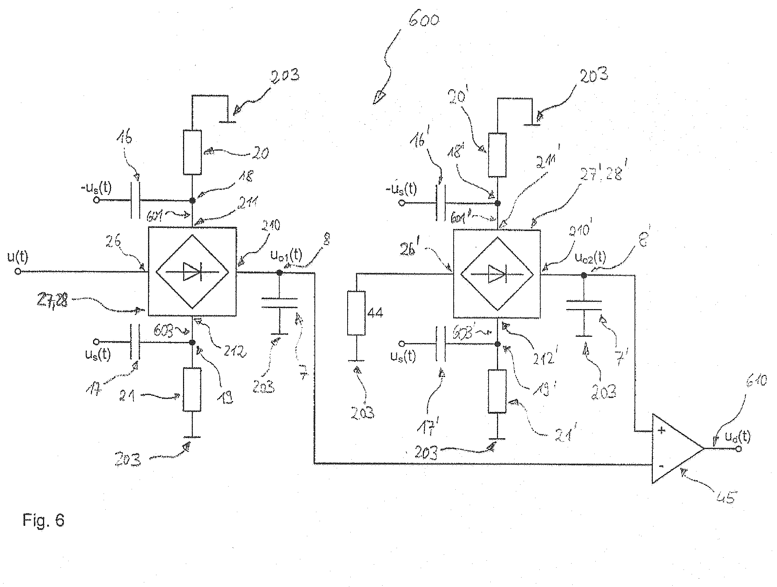

Fig. 6 zeigt ein Blockschaltbild einer Anordnung 600 zum Abtasten Signals mit einer gedoppelten Abtastbrücke 27, 28, 27' 28' mit gemeinsamem Bezugspotential gemäß einem Ausführungsbeispiel der vorliegenden Erfindung. Bei der Abtastbrücke 27, 28, 27', 28' kann es sich um eine symmetrisch aufgebaute Abtastbrücke 27,28, 27' 28' handeln. Es kann sich bei diesen Abtastbrückenjedoch auch um eine unsymmetrisch aufgebaute Abtastbrücken oder eine beliebige Kombination von symmetrisch aufgebauten Abtastbrücken und unsymmetrisch aufgebauten Abtastbrücken handeln. In Fig. 6 ist selilieβlich eine Abtastsclialtung 600 mit zwei symmetrisch aufgebauten Abtastbrücken 27, 28, 27', 28' dargestellt, welche insbesondere über die Temperatur auch ohne Regeleinrichtung ein nahezu gleichspannungsfreies Ausgangssignal u_{d}(t) am Ausgang 610 erzeugen kann.

In anderen Worten mag die Anordnung der Hauptabtastbrückc 27, 28 und der Nebenabtastbrücke 27', 28" den Einfluss eines variablen Temperaturverlaufs auf das Ausgangssignal u_{d}(t) im Wesentlichen kompensieren. Im Gegensatz zu den Ausführungsbeispielen aus Fig. 4 und Fig. 5 mit jeweils nur einer einzigen Abtastbrücke kommen bei der Anordnung 600 zwei im Wesentlichen identisch aufgebaute Abtastbrücken 27, 28, 27', 28' zum Einsatz. Die beiden Abtastbrücken sind beispielsweise als einfache Brückenschaltung 27, 27' oder als gedoppelte Brückenschaltung 28, 28' ausgeführt, also als eine Brückenschaltung 28 mit jeweils zwei oder einer Vielzahl von Dioden 22' 22", 23' 23", 24' 24", 25' 25"_{.} Beide Abtastbrücken 27, 28, 27' 28' werden mit den selben Abtastsignalen uₛ(t) und -us(t) angesteuert, wobei das Eingangssignal u(t) im Wesentlichen nur der ersten Abtastbrücke 27, 28 oder Hauptabtastbrücke 27, 28 zugeführt wird. Die zweite Abtastbrücke 27', 28' ist an ihrem Eingang 26' oder an ihrem Eingangsanschluss 26' mit einem Widerstand 44 abgeschlossen. Der Abschlusswiderstand 44 kann so gewählt werden, dass der Eingangsanschluss 26' im Wesentlichen reflexionsfrei abgeschlossen ist. Diesem für die symmetrisch aufgebaute Abtastbrücke beschriebenem Aufbau entspricht im Wesentlichen auch der Aufbau der Anordnung 600 bei dem Einsatz einer unsymmetrisch aufgebauten Abtastbrücke, wobei die Anschlüsse 19, 19' und somit das positive Abtastsignal uₛ(t) entfällt, so dass im Wesentlichen lediglich das negative Abtastsignale -u,(t) existiert.

Bei der Zuführung der Abtastsignale uₛ(t) und -uₛ(t) zu den Abtastknoten 18,19 oder 18', 19' sollte eine ausreichende Isolation zwischen beiden Abtastbrücken 27, 28, 27' 28' sichergestellt werden. Bei Verwendung von gemeinsamen Abtastknoten 18, 18' oder 19, 19' könnten die positiven Abtastknoten 19, 19' oder die negativen Abtastknoten 18, 18' nicht ausreichend voneinander isoliert sein. Der Knoten 18 soll von dem Knoten 18' und der Knoten 19 soll von dem Knoten 19' isoliert sein. Es sollte in einem Ausführungsbeispiel darauf geachtet werden, dass die Abtastbrücken 27, 28 und 27' 28' nicht direkt durch die Leitungen 601 und 603 oder 601' und 603'miteinander verbunden werden. In anderen Worten sollte auf eine galvanische Trennung zwischen der Leitung 601 und 601' geachtet werden sowie auf eine galvanische Trennung zwischen der Leitung 603 und 603'. Bei der Erzeugung der Abtastsignale sollte möglichst früh in der Signalkette auf eine Trennung der Abtastsignale für die beide Abtastbrücken geachtet werden. Beispielsweise kann eine frühe Trennung in einer Signalflussrichtung vor einem Symmetrierglied 707 (nicht gezeichnet in Fig. 6) erfolgen. In anderen Worten mag jede Abtastbrücke ein ihr eigens zugeordnetes Symmetrierglied aufweisen. Die Leitungen 601 und 601 bzw. 603 und 603' können in einem Beispiel die im Wesentlichen gleiche Länge aufweisen. In einem anderen Beispiel, in dem die Leitungen 60 und 601' bzw. 603 und 603' nicht die gleiche Länge aufweisen, sollte die Anordnung so erfolgen, dass die an den beiden Abtastbrücken ankommenden Signalamplituden der Abtastsignale in den Leitungen 601, 601, 603, 603' im Wesentlichen identisch sind. Unterschiedliche Signallaufzeiten, beispielsweise durch unterschiedliche Leitungslängen, können akzeptiert werden, da lediglich ein Gleichspannungsoffset kompensiert wird, der sich im zeitlichen Mittel ausbildet.

Die Hauptabtastbrücke 27, 28 liefert das Hauptausgangssignal Uₒ₁(t) und die Nebenabtastbrücke 27', 28' liefert das Nebenausgangssignal uₒ₂(t). Die beiden Ausgangssignale uₒ₁(t) und uₒ₂(t) der Abtastbrücken 27, 28,27', 28' werden einem Differenzverstärker 45 zugeführt, welcher die Differenz beider Signale bildet und gleichzeitig verstärkt. Dazu ist der Hauptausgangsanschluss 210 über den Knoten 8, der mit dem Kondensator 7 verbunden ist, mit dem negativen Eingang des Differenzverstärkers 45 verbunden und der Nebenausgangsanschluss 210' über den Knoten 8' der mit dem Kondensator 7' verbunden ist, mit dem positiven Eingang des Differenzverstärkers 45 verbunden. Beide Ausgangssignale uₒ₁(t) und uₒ₂(t) weisen im Wesentlichen den gleichen Gleichspannungsanteil auf. Das Ausgangssignal u_{d}(1) des Differenzverstärkers 45 wird an dem Ausgang 610 bereitgestellt. Wegen dem Bereitstellen der beiden Ausgangssignale uₒ₁(1) und uₒ₂(t) an unterschiedlichen Eingängen mit unterschiedlicher Polarität, heben sich im Differenzverstärker 45 die Gleichspannungsanteile der Ausgangssignale uₒ₁(t) und uₒ₂(t) auf, die auf eine Asymmetrie in den Abtastsignalen uₛ(t) und -uₛ(t) zurückzuführen sind. Eine überlagerte Gleichspannung am Ausgang 210, 210' die durch eine Asymmetrie in dem Aufbau der Abtastbrücke 27, 28 und/oder die durch eine Asymmetrie in den Aufbau der Abtastbrücke 27', 28' beispielsweise durch unterschiedliche Bauteiltoleranzen, selbst verursacht wird, mag durch die Schaltungsanordnung 600 jedoch im Wesentlichen nicht kompensiert werden. Somit bleibt eine durch eine Asymmetrie in den beiden Abtastbrücken 27, 28 oder 27' 28'selbst verursachte überlagerte Gleichspannung am Ausgang 610 erhalten, solange sich die Asymmetrie nicht zufällig gegenseitig aufhebt. Eine Asymmetrie in den beiden Abtastbrücken 27, 28 oder 27' 28' kann z.B. durch Bauteiltoleranzen oder parasitäre Elemente in den Bauelementen oder Dioden verursacht werden. In anderen Worten, mögen die Asymmetrien, die durch den Aufbau der Abtastbrücken innerhalb der jeweiligen Abtastbrücke erzeugt werden, zu unterschiedlichen Offsetspannungen in den Ausgangssignalen uₒₜ(t) und uₒ₂(t) führen. Werden diese im Differenzverstärker subtrahiert kann eine unerwünschte überlagerte Restspannung im Signal u_{d}(t) übrig bleiben, wenn sich die Fehler durch die Bauteiltoleranzen nicht gegenseitig aufheben.

Gemäß einem Aspekt der Erfindung kann mittels der erfindungsgemäßen Abtastvorrichtung erreicht werden, dass eine kostengünstige, einfach aufgebaute, insbesondere in Bezug auf die Signalintegrität robuste und für die Serienfertigung geeignete Abtastschaltung für die Füllstandmesstechnik bereitgestellt werden kann. Die erfindungsgemäße Abtastvorrichtung 27, 28 oder Schaltungsanordnung 27, 28 vermeidet im Wesentlichen einen Eingriff einer Ausgleichsschaltung 12 in einer Signalrichtung vor dem Zwischenfrequenzverstärker 13, 30.

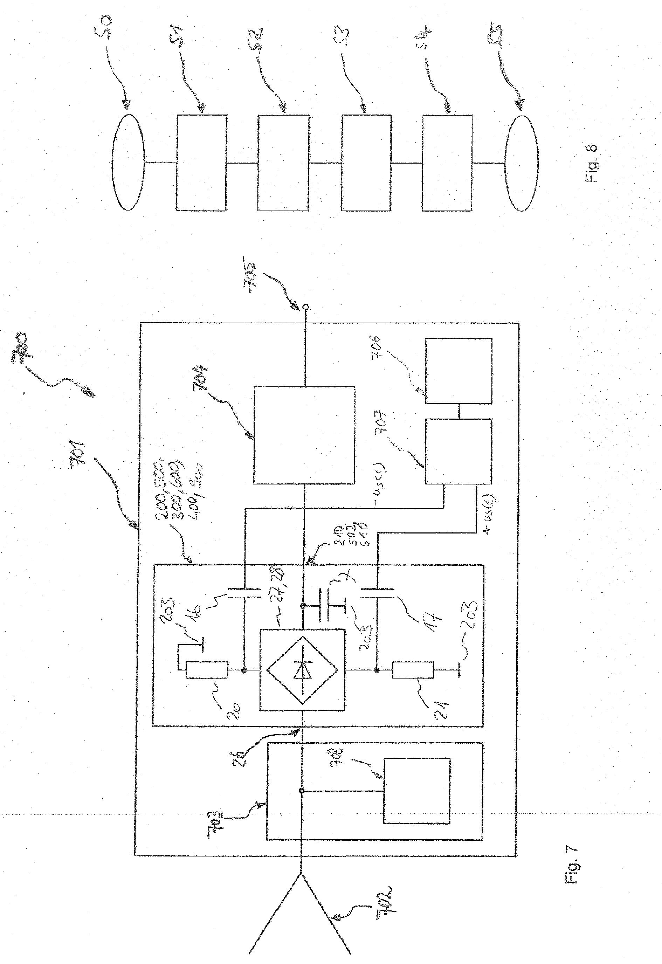

Fig. 7 zeigt ein Blockschaltbild 700 eines Messgeräts 701 mit einer Abtastvorrichtung 200, 300, 400, 500, 600 gemäß Ausführungsbeispiel der vorliegenden Erfindung. Das Messgerät 701 weist eine Antenne 702 auf. Im Falle des Ausnutzens des Prinzips der geführten Mikrowelle zur Füllstandmessung kann eine Einkoppeleinrichtung oder eine Einkopplung mit angeschlossener Messsonde anstelle der Antenne 702 verwendet werden. Diese Antenne 702 oder Einkopplung wird von der Sende-/Empfangseinrichtung 703 bedient, über die ein Sendeimpuls erzeugt und ausgesendet wird und ein Reflexionssignal empfangen wird. Das Reflexionssignal, das der Abtastvorrichtung über den Eingangsanschluss 26 zugeführt wird, wird in der Abtastvorrichtung 200, 300, 400, 500, 600abgetastet. Das abgetastete Signal wird der Signalverarbeitungseinrichtung 704 über den Ausgang 210, 502, 610 zugeführt. Die Signalverarbeitungseinrichtung 704 stellt nach einer Signalaufbereitung an der externen Schnittstelle 705 ein Signal bereit, welches dem ermittelten Messwert entspricht, beispielsweise einem Füllstand. Die Sende-/Empfangseinrichtung 703 weist einen Sendepulsgenerator 708 zum Erzeugen eines Signals auf, welches an der zu messenden Fläche reflektiert werden soll. Das Messgerät 701 weist ferner den Abtastpulsgenerator 706 und das Symmetrierglied 707 auf. Der Abtastpulsgenerator 706 erzeugt den regelmäßigen Abtastpuls und das Symmetrierglied 707 oder der Balun 707 wandelt den Abtastpuls in das positive und/oder negative Abtastsignal uₛ(t) und/oder -uₛ(t) um, welches über die Kondensatoren 16, 17 den entsprechenden Abtastanschlüssen zugeführt wird.

Bei Messgerät 701 kann es sich um ein Füllstandmessgerät oder um ein Grenzstandmessgerät handeln, welches die Freifeldausbreitung oder das Prinzip der geführten Mikrowelle ausnutzt, um eine Laufzeitmessung durchzuführen.

Das Messgerät, das in dem Blockschaltbild in Fig. 7 dargestellt ist, nutzt einen. Sendepuls, der im Sendepulsgenerator 708 generiert wird. Ein Teil des Sendepulses oder ein Teil der Energie des Sendepulses gelangt direkt zum Eingang 26 der Abtastschaltung 200, 300, 400, 500, 600 und dient als Referenzsignal. Der andere Teil gelangt zur Antenne 702 bzw. zur Messsonde bei Anwendung des Prinzips der geführten Mikrowelle. Dieser andere Teil des Sendepulses wird gesendet. Der an der Füligutoberfläche reflektierte Puls gelangt danach über die Sende-/Empfangseinheit 703 ebenfalls zum Eingang 26 der Abtastschaltung 200, 300, 400, 500, 600.

Nach der sequentiellen Abtastung der dem Abtaster zugeführten Signale in der Abtastschaltung 200, 300,400, 500, 600, entsteht eine Echokurve, welche in der Signalverarbeitungseinrichtung 704 aufbereitet und weiterverarbeitet wird.

Die Abtastschaltung 200, 300,400, 500, 600 kann die symmetrisch aufgebauten Abtastbrücken 27, 28 aufweisen.

Die Pulse zur Ansteuerung der Abtasteinrichtung werden im Abtastpulsgenerator 706 generiert, im Symmetrierglied 707 symmetriert und danach der Abtastbrücke zugeführt.

In einem anderen Ausführungsbeispiel kann jedoch auch eine unsymmetrisch aufgebaute Abtastbrücke 900 eingesetzt werden. Bei einem entsprechenden Aufbau eines Messgeräts mit der unsymmetrischen Abtastbrücke 900 kann das Symmetrierglied 707, der Kondensator 17 und das passive Bauelement 21 entfallen und der Kondensator 7 wird durch den Kondensator 907 ersetzt.

Fig. 8 zeigt ein Flussdiagramm eines Verfahrens zum Abtasten eines Signals mit einer symmetrisch aufgebauten Abtastvorrichtung gemäß einem Ausführungsbeispiel der vorliegenden Erfindung.

Aus dem Ruhezustand S0 kommend wird das abzutastende Signal im Schritt S1 an einen Eingangsanschluss 26 einer Abtastbrücke 27, 28 einer Abtastvorrichtung 200, 300, 400, 500, 600 angelegt.

Im Schritt S2 wird ein erstes Abtastsignal +uₛ(t) an einem positiven Abtastanschluss 212 der Abtastvorrichtung bereitgestellt und ein zweites Abtastsignal -uₛ(t) an einem negativen Abtastanschluss 211 der Abtastvorrichtung. Die Bereitstellung des ersten Abtastsignals +uₛ(t) und des zweiten Abtastsignals -uₛ(t) erfolgt in einem Beispiel im Wesentlichen parallel oder gleichzeitig.

Im Schritt S3 erfolgt das Bereitstellen eines Ausgangssignals u₀(t) an dem Ausgangsanschluss 210 der Abtastvorrichtung 200, 300, 400, 500, 600 und im Schritt S4 wird der positive Abtastanschluss über ein erstes passives Bauelement der Abtastvorrichtung und der negative Abtastanschluss über ein zweites passives Bauelement zu einem gemeinsamen Potenzial entladen.

Danach endet das Verfahren in dem Ruhezustand S5.

Ein Verfahren zum Abtasten eines Signals mit einer unsymmetrisch aufgebauten Abtastvorrichtung sieht in Schritt S2 lediglich das Erzeugen eines ersten Abtastsignals -uₛ(t) an einem negativen Abtastanschluss der Abtastvorrichtung vor. Außerdem wird im Schritt S4 lediglich der negative Ausgangsanschluss 211" zu dem gemeinsamen Potenzial entladen.

Gemäß einem Aspekt der Erfindung wird das Abtasten eines Signals mit einer Abtastbrücke 27, 28 beschrieben, deren Abtastanschlüsse 211, 212 miteinander verbunden sind.

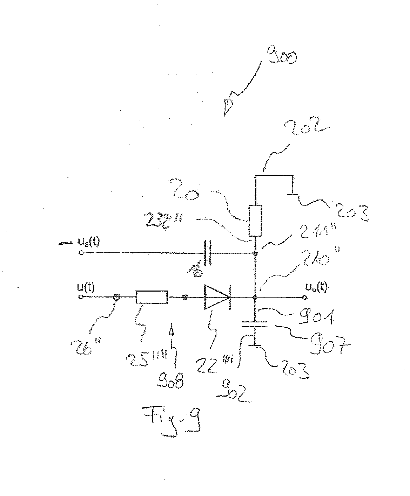

Fig. 9 zeigt ein Blockschaltbild einer Anordnung zum Abtasten eines Signals mit einer unsymmetrisch aufgebauten Abtastbrücke einem Ausführungsbeispiel der vorliegenden Erfindung.

Das negative Abtastsignal -uₛ(t) wird über den Kondensator 16 an den negativen Abtastanschluss 211" zugeführt, der im Wesentlichen dem Ausgangsanschluss 210" entspricht. Ein Abtastsignal an dem Abtastanschluss 211" kann die Diode 22" " und den Widerstand 25"" , die den Eingangsanschluss 26" und den Ausgangsanschluss 210" miteinander verbinden und den Brückenzweig 908 bilden, in einen leitenden Zustand schalten. In diesem leitenden Zustand wird das abzutastende Signal u(t) an den Ausgang und insbesondere an den Kondensator 907 weitergereicht. Dort kann es abgegriffen werden und einer Signalverarbeitung zur Verfügung gestellt werden. Durch geeignete Dimensionierung der Bauelemente in der Abtastschaltung, die sich an der Dimensionierung der Abtastbrücke 27 orientiert, kann sichergestellt werden, dass das Nutzsignal u₀(t) im Wesentlichen nicht über den Widerstand 20 zur Schaltungsmasse abgeleitet wird. Der Widerstand 20 dient im Wesentlichen zum Entladen des Kondensators 16, welcher sich durch das periodische Abtastsignal - uₛ(1) zu einem gewissen Grad aufladen kann. Der erste Anschluss 232" des Widerstandes 20 oder des passiven Bauelements 20 ist mit dem Ausgangsanschluss 210" und dem ersten Anschluss 901 des Kondensators verbunden. Der zweite Anschluss 202 des Widerstandes 20 ist mit zweiten Anschluss 902 des Kondensators 907 direkt verbunden.

Ergänzend ist darauf hinzuweisen, dass "umfassend" und. "aufweisend" keine anderen Elemente oder Schritte ausschließt und "eine" oder "ein" keine Vielzahl ausschließt. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Abtastvorrichtung (200, 200"', 300), aufweisend:
eine Abtastbrücke (27, 27"', 28);
ein erstes passives Bauelement (21);
ein zweites passives Bauelement (20);
wobei die Abtastbrücke (27, 27"', 28) zumindest zwei Dioden (22, 23) aufweist;
wobei jede der Dioden (22, 23,) eine Anode und eine Kathode aufweist;
wobei die zumindest zwei Dioden (22, 23) in Reihe geschaltet sind und einen ersten Brückenzweig (208) bilden, so dass die Anode der einen Diode (22) mit der Kathode der anderen Diode (23) an einem Eingangsanschluss (26) verbunden ist;
wobei zumindest zwei passive rückenbauelemente (24, 24"', 25, 25"') in Reihe geschaltet sind und einen zweiten Brückenzweig (209, 209"') bilden, so dass eine Verbindung (210, 210"') zwischen den zumindest zwei passiven Brückenbauelementen (24, 24"', 25, 25"') einen Ausgangsanschluss (210, 210"') bilden;
wobei die beiden Brückenzweige (208, 209, 209"') parallel geschaltet sind, so dass eine freie Anode einer Diode (23) des ersten Brückenzweigs (208) mit einem freien Ende eines passiven Brückenbaueleznents (24,24"') des zweiten Brückenzweigs (209, 209"') an einem positiven Abtastanschluss (212) verbunden ist; und
eine freie Kathode einer Diode (22) des ersten Brückenzweigs (208) mit einem freien Ende eines anderen passiven Brückenbauelements (25, 25"') des zweiten Brückenzweigs (209, 209"') an einem negativen Abtastanschluss (211) verbunden ist;
wobei ein erster schluss (231) des ersten passiven Bauelements (21) mit dem positiven Abtastanschluss (212) verbunden ist;
wobei ein erster schluss (232) des zweiten passiven Bauelements (20) mit dem negativen Abtastanschluss (211) verbunden ist;
wobei ein zweiter schluss (201) des ersten passiven Bauelements (21) mit eine zweiten Anschluss (202) des zweiten passiven Bauelements (20) verbunden ist, so dass die beiden zweiten Anschlüsse (201, 202) auf einem gemeinsamen Potenzial liegen.

2. Abtastvorrichtung (200, 200"', 300) nach Anspruch 1, wobei die zumindest zwei passiven Brückenbauelemente (24, 24"' 25, 25"') zumindest zwei Dioden (24, 25) sind.

3. Abtastvorrichtung (200, 200"' 300) nach Anspruch 1 oder 2, wobei das gemeinsame Potenzial ein Massepotential ist.

4. Abtastvorrichtung (200, 200"' 300) nach einem der Ansprüche 1 bis 3, wobei zumindest eine Diode (22, 23, 24, 25) aus der Reihenschaltung von zumindest zwei Dioden (22', 22", 23', 23", 24', 24", 25', 25") gebildet wird.

5. Abtastvorrichtung (200, 200"' 300) nach einem der Ansprüche 1 bis 4, wobei an dem Ausgangsanschluss (210, 210"') ein Kondensator (7) angeschlossen ist.

6. Abtastvorrichtung (200, 200"' 300) nach einem der Ansprüche 1 bis 5, wobei an dem Ausgangsanschluss (210, 210"') zumindest ein Differenzverstärker (31, 38) angeschlossen ist.

7. Abtastvorrichtung (200, 200"' 300) nach einem der Ansprüche 1 bis 6, wobei an dem Ausgangsanschluss (210, 210"') eine Regeleinrichtung (501) angeschlossen ist.

8. Abtastvorrichtung (200, 200"', 300) nach Anspruch 7, wobei die Regeleinrichtung (501) einen Digital/Analog-Wandler (37) und/oder ein digitales Potentiometer aufweist.

9. Abtastvorrichtung (200, 200"', 300) nach einem der Ansprüche 1 bis 8, wobei die Abtastvorrichtung (200, 200"', 300, 600) eine weitere Abtastbrücke (27', 28') ausweist.

10. Abtastvorrichtung (200, 200"', 300) nach einem der Ansprüche 1 bis 9, wobei die Dioden (22, 22', 22", 23, 23', 23", 24, 24', 24", 25, 25', 25") der Abtastbrücke (27, 28) Schottky-Dioden sind.

11. Abtastvorrichtung (900), aufweisend
einen Abtastbrückenzweig (908) mit zumindest einem passiven Brückenbauelement (25"") und mit zumindest einer Diode (22"");
wobei ein freies Ende (26") des passiven Brückenbauelements (25"") einen Eingangsanschluss (26") aufweist;
wobei ein anderes Ende des passiven Brückenbauelements (25"") mit einer Anode der zumindest einen Diode (22"") verbunden ist;
wobei die Kathode der zumindest einen Diode (22"") einen Ausgangsanschluss (210") aufweist-,
wobei der Ausgangsanschluss (210") mit einem negativen Abtastanschluss (211"), einem ersten Anschluss (901) eines Kondensators (907) und einem ersten Anschluss (232") eines passiven Bauelements (20) verbunden ist;
wobei ein zweiter Anschluss (902) des Kondensators (907) und ein zweiter Anschluss (202) des passiven Bauelements (20) auf einem gemeinsamen Potenzial liegen.

12. Messgerät (700) aufweisend:
eine Sende-/Empfangseinrichtung (703);
eine Abtastvorrichtung (200,200"', 300, 900) nach einem der Ansprüche 1 bis 10 oder 11;
eine Signalverarbeitungseinrichtung (704);
wobei die Sende-/Empfangseinrichtung (703) zum Aussenden eines Sendesignals und zum Empfangen eines Empfangssignals eingerichtet ist; und
wobei die Sende-/Empfangseinrichtung (703) zum Bereitstellen des Empfangssignals an einen Eingangsanschluss (26) der Abtastvorrichtung (200, 200"'" 300, 900) eingerichtet ist;
wobei die Abtastvorrichtung (200,200"', 300, 900) zum Bereitstellen eines Ausgangssignals über einen Ausgangsanschluss (210, 210", 210"',,) der Abtastvorrichtung (200, 210"', 300, 900) an die Signalverarbeitungseinrichtung (704) eingerichtet ist;
wobei die Signalverarbeitungseinrichtung (704) zum Ermitteln und Bereitstellen eines Messwertes aus dem Ausgangssignal eingerichtet ist.

13. Verfahren zum Abtasten eines Signals mit einer Abtastvorrichtung (200, 200"', 300, 900) nach einem der Ansprüche 1 bis 10, das Verfahren aufweisend:
Anlegen des Signals an einen Eingangsanschluss einer Abtastbrücke der Abtastvorrichtung;
Bereitstellen eines ersten Abtastsignals an einem positiven Abtastanschluss der Abtastvorrichtung;
Bereitstellen eines zweiten Abtastsignals an einem negativen Abtastanschluss der Abtastvorrichtung;
Bereitstellen eines Ausgangssignals an dem Ausgangsanschluss der Abtastvorrichtung;
Entladen des positiven Abtastanschlusses über ein erstes passives Bauelement der Abtastvorrichtung und Entladen eines negativen Abtastanschlusses über ein zweites passives Bauelement zu einem gemeinsamen Potenzial.

14. Computerlesbares Speichermedium, auf dem ein Programm gespeichert ist, wobei das Programm angepasst ist, wenn es von einem Prozessor ausgeführt wird, das Verfahren zum Abtasten eines Signals mit einer Abtastvorrichtung nach Anspruch 13 auszuführen.

15. Computer-Programmprodukt, weiches angepasst ist, wenn es von einem Prozessor ausgeführt wird, das Verfahren zum. Abtasten eines Signals mit einer Abtastvorrichtung nach Anspruch 13 auszuführen.
